# EUROPEAN PATENT APPLICATION

(11) **EP 4 708 410 A1**
(43) Date of publication of application: **11.03.2026**
(21) Application number: 25198878.8
(22) Date of filing: 28.08.2025
(51) Int. Cl.: H01M 8/04014, H01M 8/2475, H01M 10/613, H01M 10/6563, H01M 16/00

(54) **FUEL CELL SYSTEM AND MONOGENERATION DEVICE**

(30) Priority: 30.08.2024 JP 2024148538; 30.08.2024 JP 2024148555; 30.08.2024 JP 2024148560
(71) Applicant: Yanmar Holdings Co., Ltd., Osaka-shi, Osaka (JP)
(72) Inventor: TAKAHASHI, Tomohiro, Osaka (JP); MORIBE, Shinji, Osaka (JP); ITO, Ryosuke, Osaka (JP); AMAKAWA, Shohei, Osaka (JP); NAKAYAMA, Naoya, Osaka (JP); OSAKI, Yuya, Osaka (JP)
(74) Representative: Sekiguchi, Kazuya

(57) **Abstract**

[Problem] To provide a technique capable of preventing an increase in fuel gas concentration at a place where an ignition source is present even if fuel gas leaks in a fuel cell system, a technique capable of easily optimizing a heat balance in the fuel cell system, or a technique capable of appropriately performing ventilation in the fuel cell system.

[Solution] An exemplary fuel cell system includes a housing having a fuel cell room including a fuel cell module, and an electrical equipment room that is partitioned from the fuel cell room and that includes a plurality of electrical devices. The housing includes a fuel cell room ventilation route that ventilates the fuel cell room and a plurality of electrical equipment room ventilation routes that ventilate the electrical equipment room. Furthermore, the housing has a ventilation route that ventilates the inside, an inlet of the ventilation route is provided on a side surface of the housing, and an outlet of the ventilation route is provided on an upper surface of the housing.

## Description

### TECHNICAL FIELD

The present invention relates to a fuel cell system and a monogeneration device.

### BACKGROUND ART

A cogeneration device to which a gas engine system is applied has been known (see, for example, Patent Document 1).

### PRIOR ART DOCUMENT

### PATENT DOCUMENT

Patent Document 1: Japanese Patent No. 6321484

### SUMMARY OF INVENTION

### TECHNICAL PROBLEM

In recent years, there has been a demand for a cogeneration device or the like using a fuel cell system including a fuel cell from a viewpoint of carbon neutrality. In the fuel cell system, when a fuel gas leaks into a package from a fuel gas supply system or the like, the leakage is detected by a gas leakage detector, and processing, such as stop of power generation, is performed. However, since there is a time lag from when the fuel gas leaks to when the gas leak detector operates, it is desirable that the concentration of the fuel gas does not become as high as possible at a location where an ignition source is present. In the fuel cell system, an electrical device that generates heat during operation and a plurality of electrical devices having different temperature requirements during use are required to be accommodated in a limited space. Therefore, it is difficult to optimize the heat balance as a thermal design in the fuel cell system. Furthermore, in the fuel cell system, an inside of the package is ventilated in order to prevent the fuel gas from staying in the package. Exhaust for the ventilation may cause a short circuit in ventilation performed in the own system or a facility installed around the own system. Note that the short circuit refers to a phenomenon in which positions of an inlet (air supply port) and an outlet (air exhaust port) of ventilation are too close to each other and air circulates in a narrow range. When the short circuit occurs, the ventilation efficiency deteriorates, and there is a possibility that insufficient ventilation occurs.

An object of the present invention is to provide a technique capable of preventing an increase in the concentration of a fuel gas at a location where an ignition source is present even if the fuel gas leaks in a fuel cell system, a technique capable of easily achieving an appropriate heat balance in the fuel cell system, or a technique capable of appropriately performing ventilation in the fuel cell system.

### SOLUTION TO PROBLEM

An exemplary fuel cell system according to the present invention includes a housing having a fuel cell room including a fuel cell module, and an electrical equipment room that is partitioned from the fuel cell room and that includes a plurality of electrical devices. The housing includes a fuel cell room ventilation route that ventilates the fuel cell room and a plurality of electrical equipment room ventilation routes that ventilate the electrical equipment room. Furthermore, the housing has a ventilation route that ventilates the inside, an inlet of the ventilation route is provided on a side surface of the housing, and an outlet of the ventilation route is provided on an upper surface of the housing.

### ADVANTAGEOUS EFFECTS OF INVENTION

According to the exemplary fuel cell system of the present invention, even if a fuel gas leaks, the concentration of the fuel gas at a location where the ignition source is present can be prevented from becoming high, and the heat balance can be easily optimized or ventilation can be appropriately performed.

### BRIEF DESCRIPTION OF DRAWINGS

FIG. 1A is a perspective view schematically illustrating a configuration of appearance of a fuel cell system.
FIG. 1B is a perspective view schematically illustrating a configuration of appearance of the fuel cell system.
FIG. 2 is a block diagram for explaining an outline of a configuration related to power generation of the fuel cell system.
FIG. 3 is a block diagram schematically illustrating a configuration of a cooling system included in the fuel cell system.
FIG. 4A is a front view schematically illustrating a configuration of an inside of a housing.
FIG. 4B is a rear view schematically illustrating a configuration of the inside of the housing.
FIG. 5 is a diagram schematically illustrating a configuration at a cross section when the housing illustrated in FIG. 4A is cut at a V-V position.
FIG. 6 is a schematic diagram illustrating an outline of a ventilation structure included in the fuel cell system.
FIG. 7 is a schematic front view for explaining details of an electrical equipment room ventilation route.
FIG. 8 is a right side schematic view for explaining details of the electrical equipment room ventilation route.
FIG. 9 is a cross-sectional view schematically illustrating arrangement of a battery in a battery case.
FIG. 10 is a cross -sectional perspective view schematically illustrating a configuration at a cross section taken at an X-X position in FIG. 4A.
FIG. 11A is a first perspective view for explaining an internal structure of a left duct room.
FIG. 11B is a second perspective view for explaining the internal structure of the left duct room.
FIG. 12 is a schematic diagram for explaining operation of the left duct room.
FIG. 13A is a first perspective view for explaining an internal structure of a right duct room.
FIG. 13B is a second perspective view for explaining the internal structure of the right duct room.
FIG. 14 is a schematic diagram for explaining operation of the right duct room.

### DESCRIPTION OF EMBODIMENTS

Embodiments of the present invention are described with reference to the drawings. Note that, in the drawings, the same or corresponding parts are denoted by the same reference characters, and descriptions thereof will not be repeated unless otherwise required.

### 1. Outline of fuel cell system

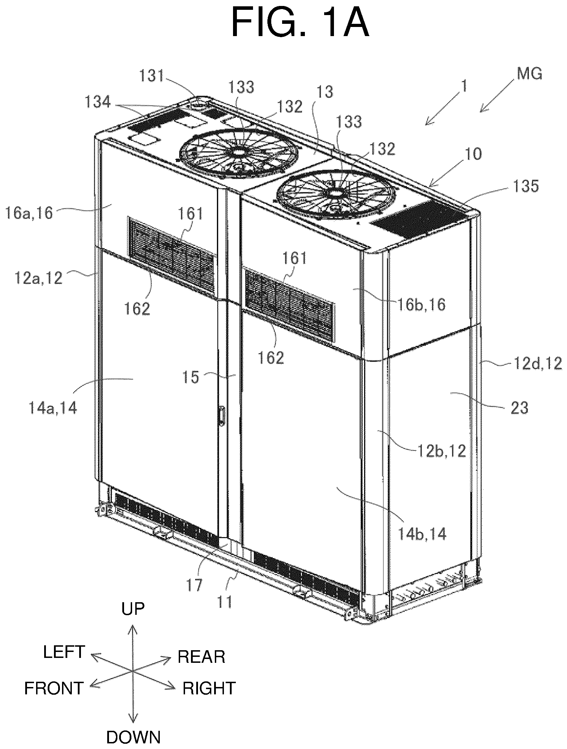

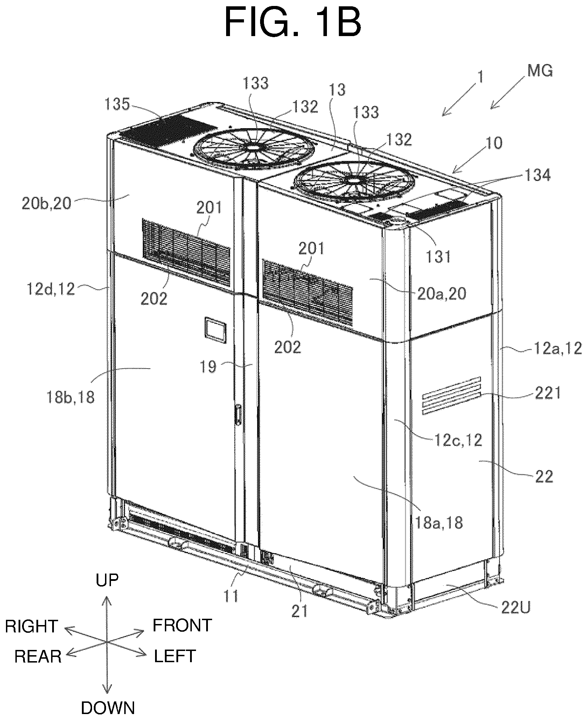

FIGS. 1A and 1B are perspective views schematically illustrating appearance of a fuel cell system 1 according to an embodiment of the present invention. A direction in which the fuel cell system 1 is viewed is different between FIG. 1A and FIG. 1B. The fuel cell system 1 can be applied to, for example, a monogeneration device MG. The monogeneration device MG has a power generation function using the fuel cell system 1. The monogeneration device MG may be composed of a single fuel cell system 1 or may be configured to use a plurality of fuel cell systems 1 in combination. Thus, the monogeneration device MG includes the fuel cell system 1. Note that this embodiment illustrates a configuration in which the fuel cell system 1 is applied to a monogeneration device MG, but the fuel cell system 1 may be applied to a cogeneration device. The cogeneration device is a combined heat and power supply system that generates electric power and recovers waste heat generated along with the electric power generation to use the waste heat for, for example, hot water supply or heating. The fuel cell system 1 can also be used as, for example, a power generator in a home, a factory, or the like.

As illustrated in FIGS. 1A and 1B, the fuel cell system 1 includes a housing 10. The housing 10 has a cuboid shape. However, the shape of the housing 10 may be appropriately changed.

In the following description of the fuel cell system 1, directions are defined as follows. A direction perpendicular to a horizontal floor surface (not illustrated) on which the housing 10 of the fuel cell system 1 is disposed is defined as an up-down direction, and the up-down direction is defined with a side on which the housing 10 is disposed with respect to the floor surface taken as an upper direction. A longitudinal direction of the housing 10 having a rectangular shape in plan view is referred to as a left-right direction, and a lateral direction is referred to as a front-rear direction. One of two side surfaces arranged in the front-rear direction is defined as a front side and the other is defined as a rear side as illustrated in FIGS. 1A and 1B. Using the front and the rear defined in FIGS. 1A and 1B, the left side and the right side are defined such that the left side is the left and the right side is the right when viewed from the front toward the rear.

These directions are names used merely for the description and are not intended to limit actual positional relationships or directions. In addition, according to the definitions of the directions described above, FIG. 1A is a perspective view of the front side of the housing 10 as viewed obliquely from the right above, and FIG. 1B is a perspective view of the rear side of the housing 10 as viewed obliquely from the left above.

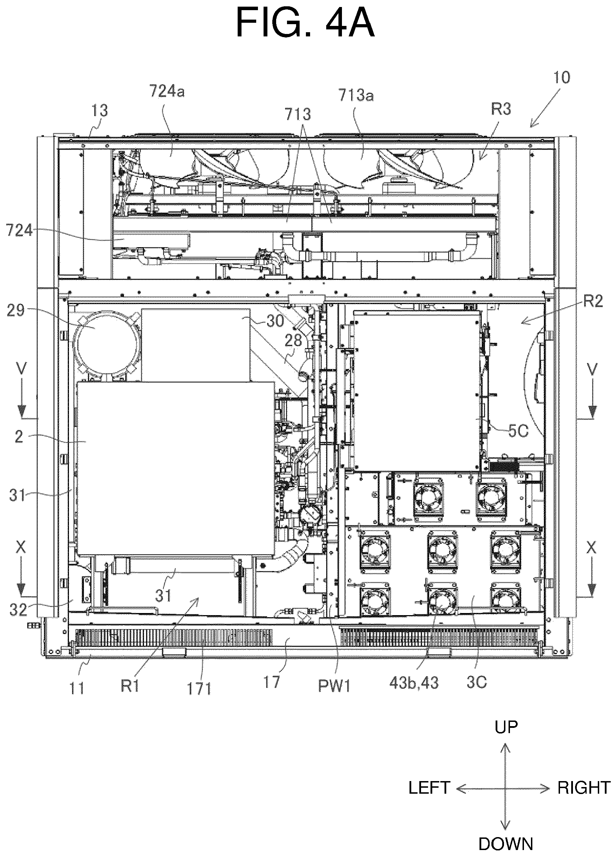

The housing 10 houses a fuel cell module 2 (refer to FIG. 4A and the like described below). The fuel cell system 1 generates electric power by using the fuel cell module 2 and a fuel gas and an oxidant gas supplied from the outside. In this embodiment, hydrogen gas is used as the fuel gas, and air is used as the oxidant gas. However, the fuel gas is not limited to the hydrogen gas, and may be, for example, a gas containing methane as a main component. Furthermore, the oxidant gas is not limited to air, and may be any gas containing oxygen.

### 1-1. Configuration Related to Power Generation

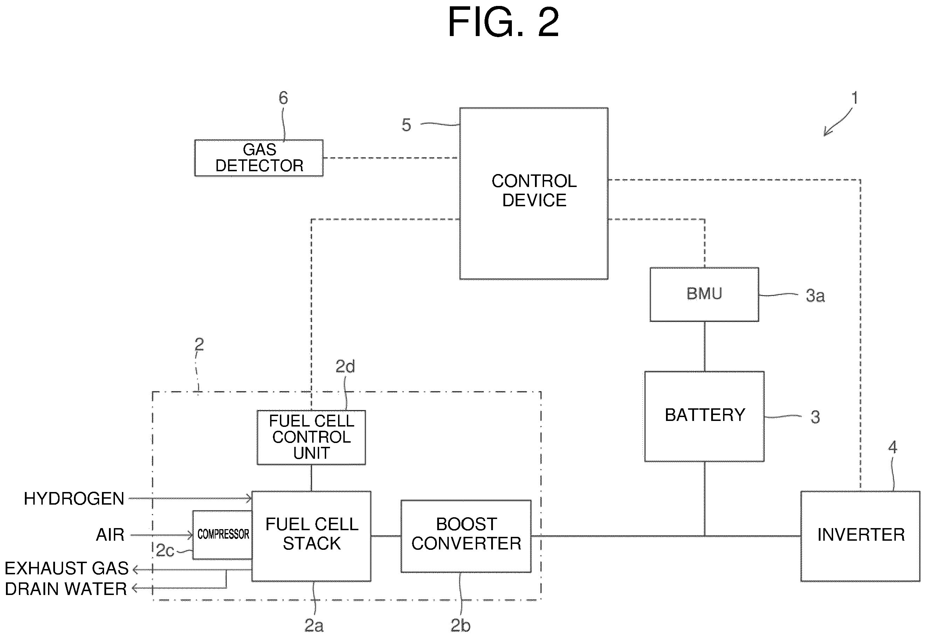

A configuration related to power generation of the fuel cell system 1 including the fuel cell module 2 will be briefly described with reference to FIG. 2. FIG. 2 is a block diagram for explaining an outline of the configuration related to power generation of the fuel cell system 1 according to the embodiment of the present invention.

As illustrated in FIG. 2, the fuel cell system 1 includes a fuel cell module 2, a battery 3, an inverter 4, and a control device 5.

Specifically, the fuel cell module 2 includes a fuel cell stack 2a, a boost converter 2b, a compressor 2c, and a fuel cell control unit 2d.

The fuel cell stack 2a is composed of a plurality of stacked cells. Each of the cells has a solid polymer electrolyte membrane, an anode, a cathode, and a pair of separators. The solid polymer electrolyte membrane is sandwiched between the anode and the cathode. The anode is a fuel electrode and includes an anode catalyst layer and a gas diffusion layer. The cathode is an air electrode and includes a cathode catalyst layer and a gas diffusion layer. The anode electrode, the solid polymer electrolyte membrane, and the cathode electrode constitute a membrane electrode assembly (MEA). The membrane electrode assembly is sandwiched by the pair of separators. Each of the separators has a plurality of grooves. Each of the grooves of one of the separators forms a flow path for hydrogen (hydrogen gas). Each of the grooves of the other separator forms a flow path for air.

On the anode side, hydrogen is decomposed into hydrogen ions and electrons by a catalyst. The hydrogen ions pass through the solid polymer electrolyte membrane and move to the cathode electrode. On the other hand, the electrons move to the cathode electrode through an external circuit. Consequently, a current is generated. That is, the fuel cell stack 2a generates electric power. On the cathode electrode side, oxygen included in air is combined with the electrons having flowed through the external circuit and the hydrogen ions having passed through the solid polymer electrolyte membrane to generate water. The generated water is included in exhaust gas to be released to the outside of the fuel cell system 1. The electric power generated by the fuel cell stack 2a is boosted by the boost converter 2b and supplied to at least one of the battery 3 and the inverters 4.

The compressor 2c is disposed in the fuel cell stack 2a to take in air from the outside of the fuel cell system 1. The air taken into the fuel cell system 1 by the compressor 2c flows into the fuel cell stack 2a via a plurality of filters (not illustrated) included inside the fuel cell system 1.

The fuel cell control unit 2d controls the individual sections of the fuel cell module 2. For example, the fuel cell control unit 2d controls an output (power generation) of the fuel cell stack 2a, driving of the compressor 2c, and the like. The fuel cell control unit 2d is communicably connected to the control device 5. The fuel cell control unit 2d transmits, for example, information related to the fuel cell module 2 to the control device 5 by communication.

The battery 3 is configured by, for example, a lithium ion battery, and stores electric power to be supplied to the inverter 4. The battery 3 may be configured by unitizing a plurality of battery cells or may be configured by a single battery cell. The battery 3 is configured to be able to receive electric power generated by the fuel cell stack 2a. The battery 3 is charged by supplying electric power from the fuel cell stack 2a to the battery 3.

The battery 3 is controlled by a battery management unit (BMU) 3a.

The BMU 3a controls, for example, input and output (charging and discharging) of the battery 3. Furthermore, the BMU 3a calculates a charge rate of the battery 3 based on information (for example, a voltage value, a current value, a temperature, and the like) acquired via various sensors (not illustrated) included in the battery 3. The charge rate of the battery 3 is also referred to as a state of charge (SOC), and means a ratio of the remaining charge capacity (at that time) to the charge capacity at the time of full charge.

The BMU 3a is communicably connected to the control device 5. The BMU 3a transmits, for example, information on the battery 3 acquired by the BMU 3a (the charge rate calculated by the BMU 3a or the like) to the control device 5 by communication.

The inverter 4 includes a substrate on which various electric components (for example, a diode, a capacitor, a power transistor, and the like) are mounted (none of which is illustrated). The inverter 4 converts electric power of a DC voltage supplied from at least one of the fuel cell stack 2a and the battery 3 into electric power of an AC voltage, and outputs the electric power of the AC voltage to the outside of the fuel cell system 1.

The inverter 4 is communicably connected to the control device 5. The inverter 4 adjusts output (output power) of the inverter 4, for example, based on an output command output from the control device 5. Furthermore, the inverter 4 transmits information on the output of the inverter 4 to the control device 5 by communication.

The control device 5 performs overall control of the fuel cell system 1. The control device 5 appropriately executes control of the individual sections communicably connected to the control device 5. The control device 5 is, for example, a computer device including an arithmetic device, an input/output unit, and a storage. The arithmetic device is a processor or a microprocessor, for example. The storage is a main storage device, such as a read only memory (ROM) and a random access memory (RAM). The storage may further include an auxiliary storage device, such as a hard disk drive (HDD) or a solid state drive (SSD).

In addition, as illustrated in FIG. 2, the fuel cell system 1 includes a gas detector 6 for ensuring safety related to use of hydrogen during power generation using the fuel cell module 2. The gas detector 6 detects leakage of hydrogen that is a fuel gas supplied to the fuel cell module 2. The gas detector 6 is communicably connected to the control device 5 and outputs detection information of hydrogen in the housing 10 to the control device 5. The control device 5 issues an alarm or executes a system stop measure in accordance with the acquired detection information of hydrogen.

### 1-2. Cooling System

The fuel cell system 1 includes a cooling system provided for the fuel cell module 2.

The cooling system will also be briefly described.

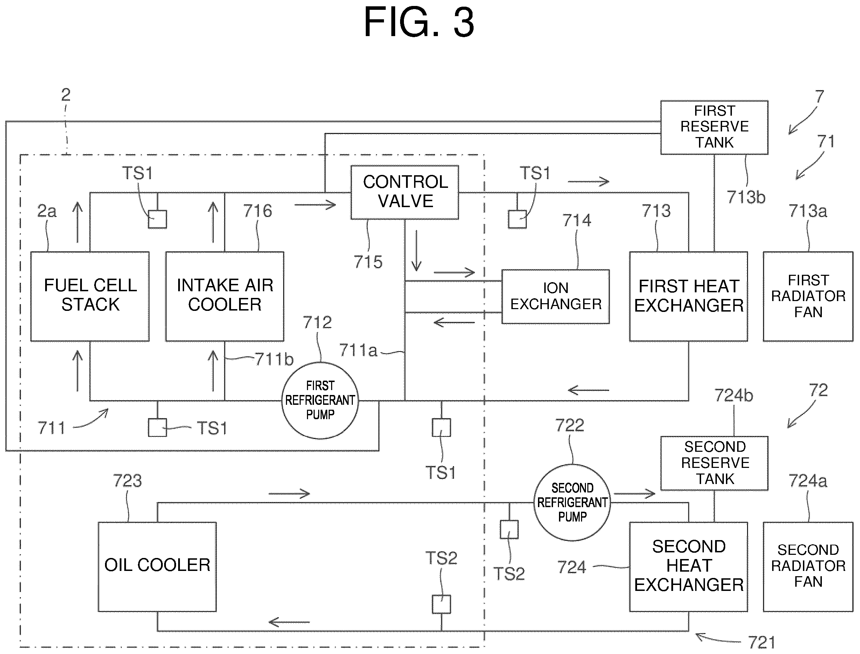

FIG. 3 is a block diagram illustrating a schematic configuration of a cooling system 7 included in the fuel cell system 1 according to the embodiment of the present invention. The cooling system 7 includes a first cooling system 71 and a second cooling system 72. The first cooling system 71 cools the fuel cell stack 2a included in the fuel cell module 2. The second cooling system 72 is for an oil cooler (an oil cooler 723 described below) that cools auxiliary machines included in the fuel cell module 2.

### 1-2-1. First Cooling System

The first cooling system 71 includes a first refrigerant circulation passage 711, a first refrigerant pump 712, a first heat exchanger 713, an ion exchanger 714, a control valve 715, an intake air cooler 716, and a plurality of first temperature sensors TS1. Note that the first refrigerant pump 712, the control valve 715, the intake air cooler 716, and some of the first temperature sensors TS1 are included in the fuel cell module 2.

The first refrigerant circulation passage 711 is a flow passage for circulating the first refrigerant. In this embodiment, cooling water is used as the first refrigerant, but the present invention is not limited to this, and, for example, cooling oil or cooling gas may be used as the first refrigerant.

The first refrigerant circulation passage 711 is connected to the fuel cell stack 2a, the first refrigerant pump 712, the first heat exchanger 713, the ion exchanger 714, the control valve 715, and the intake air cooler 716. More specifically, the fuel cell stack 2a, the first refrigerant pump 712, and the first heat exchanger 713 are connected in series. The ion exchanger 714 is connected in parallel to the first heat exchanger 713. Specifically, the first refrigerant circulation passage 711 includes a first bypass flow passage 711a that connects a flow passage between the first heat exchanger 713 and the first refrigerant pump 712 to a flow passage between the fuel cell stack 2a and the first heat exchanger 713. The ion exchanger 714 is connected in parallel to the first bypass flow passage 711a. The control valve 715 is disposed in a connecting portion between the flow passage between the fuel cell stack 2a and the first heat exchanger 713 and the first bypass flow passage 711a.

The intake air cooler 716 is connected in parallel to the fuel cell stack 2a. Specifically, the first refrigerant circulation passage 711 includes a second bypass flow passage 711b that connects a flow passage between the first refrigerant pump 712 and the fuel cell stack 2a to the flow passage between the fuel cell stack 2a and the first heat exchanger 713 (specifically, the control valve 715). The intake air cooler 716 is connected in series to the second bypass flow passage 711b.

The first temperature sensors TS1 are disposed in a flow passage between the first refrigerant pump 712 and the fuel cell stack 2a and a flow passage between the fuel cell stack 2a and the control valve 715. In addition to these, the first temperature sensors TS1 are disposed in a flow passage between the control valve 715 and the first heat exchanger 713 and a flow passage between the first heat exchanger 713 and the first refrigerant pump 712. The first temperature sensors TS1 detect a temperature of the first refrigerant circulating in the first refrigerant circulation passage 711. The number and arrangement of the temperature sensors TS1 may be changed as appropriate.

The first refrigerant pump 712 is configured by an electric pump and is driven by electric power supplied from the control device 5 (refer to FIG. 2). When the first refrigerant pump 712 is driven, the first refrigerant circulates in the first refrigerant circulation passage 711. More specifically, the first refrigerant discharged from the first refrigerant pump 712 flows into each of the fuel cell stack 2a and the intake air cooler 716. The first refrigerant that has flowed into the fuel cell stack 2a flows inside the fuel cell stack 2a. To be specific, the first refrigerant that has flowed into the fuel cell stack 2a passes through the plurality of cells constituting the fuel cell stack 2a. Thus, the fuel cell stack 2a is cooled.

The intake air cooler 716 cools the air (intake air) supplied to the fuel cell stack 2a by the compressor 2c. To be specific, the air taken in from the outside of the fuel cell system 1 by the compressor 2c hits the intake air cooler 716. The air that has hit the intake air cooler 716 is cooled by exchanging heat with the first refrigerant flowing inside the intake air cooler 716.

The first refrigerant discharged from the fuel cell stack 2a and the intake air cooler 716 flows into the control valve 715. The control valve 715 is configured by, for example, a three way valve. The control valve 715 controls a flow direction and a flow rate of the first refrigerant flowing into the control valve 715 in accordance with an opening degree of the control valve 715. For example, when the opening degree of the control valve 715 is 100%, the entire first refrigerant flowing into the control valve 715 is supplied to the first heat exchanger 713. When the opening degree of the control valve 715 is 50%, the first refrigerant flowing into the control valve 715 is supplied to the first heat exchanger 713 and the first bypass flow passage 711a (the ion exchanger 714) by half. When the opening degree of the control valve 715 is 0%, the entire first refrigerant flowing into the control valve 715 is supplied to the first bypass flow passage 711a (the ion exchanger 714).

The first heat exchanger 713 cools the first refrigerant by exchanging heat between the air (wind) hitting the first heat exchanger 713 and the first refrigerant flowing inside the first heat exchanger 713. In this embodiment, the first heat exchanger 713 is a so-called radiator. The air is sent to the first heat exchanger 713 by a first radiator fan 713a. The first radiator fan 713a is composed of an electric fan and is driven by electric power supplied from the control device 5.

Note that a first reserve tank 713b is connected to the first heat exchanger 713. The first reserve tank 713b is connected to the first refrigerant circulation passage 711 in addition to the first heat exchanger 713. More specifically, the first reserve tank 713b is connected to a flow passage between the first heat exchanger 713 and the first refrigerant pump 712. The first reserve tank 713b is also connected to a flow passage between the fuel cell stack 2a and the control valve 715. The first reserve tank 713b is configured by, for example, a sealed (pressurized) reserve tank, and the refrigerant in the first refrigerant circulation passage 711 circulates via the first reserve tank 713b.

The ion exchanger 714 includes an ion exchange filter and the like. When the first refrigerant flows inside the ion exchanger 714, the impurity ions are removed from the first refrigerant. The impurity ions are eluted into the first refrigerant from, for example, a pipe constituting the first refrigerant circulation passage 711. When the impurity ions eluted into the first refrigerant are increased, the conductivity of the first refrigerant is increased, whereas when the impurity ions are decreased, the conductivity of the first refrigerant is decreased. The ion exchanger 714 enables the conductivity of the first refrigerant to be reduced by removing the impurity ions from the first refrigerant.

### 1-2-2. Second Cooling System

The second cooling system 72 includes a second refrigerant circulation passage 721, a second refrigerant pump 722, an oil cooler 723, a second heat exchanger 724, and a plurality of second temperature sensors TS2. Note that the oil cooler 723 and some of the second temperature sensors TS2 are included in the fuel cell module 2.

The second refrigerant circulation passage 721 is a flow passage for circulating the second refrigerant. In this embodiment, cooling water is used as the second refrigerant, but the present invention is not limited to this, and, for example, cooling oil or cooling gas may be used as the second refrigerant.

The second refrigerant circulation passage 721 is connected to the second refrigerant pump 722, the oil cooler 723, and the second heat exchanger 724. More specifically, the second refrigerant pump 722, the oil cooler 723, and the second heat exchanger 724 are connected in series.

The second temperature sensors TS2 are included in a flow passage between the second heat exchanger 724 and the oil cooler 723 and a flow passage between the oil cooler 723 and the second refrigerant pump 722. The second temperature sensors TS2 detect a temperature of the second refrigerant circulating in the second refrigerant circulation passage 721.

The second refrigerant pump 722 is composed of an electric pump and is driven by electric power supplied from the control device 5. When the second refrigerant pump 722 is driven, the second refrigerant circulates in the second refrigerant circulation passage 721. More specifically, the second refrigerant discharged from the second refrigerant pump 722 flows into the oil cooler 723 via the second heat exchanger 724.

The oil cooler 723 cools cooling oil for cooling a compressor 2c (particularly, a motor unit of the compressor 2c) and the like included in the fuel cell module 2. Specifically, the cooling oil having flowed through the compressor 2c and the like flows into the oil cooler 723. The cooling oil that has flowed into the oil cooler 723 is cooled by exchanging heat with the second refrigerant that flows (separately from the cooling oil) inside the oil cooler 723.

The second heat exchanger 724 cools the second refrigerant by exchanging heat between air (wind) hitting the second heat exchanger 724 and the second refrigerant flowing inside the second heat exchanger 724. The second heat exchanger 724 is a so-called radiator. The air is sent to the second heat exchanger 724 by a second radiator fan 724a. The second radiator fan 724a is composed of an electric fan and is driven by electric power supplied from the control device 5.

Note that a second reserve tank 724b is connected to the second heat exchanger 724. The second reserve tank 724b is composed of, for example, an open-type reserve tank, and stores the second refrigerant. When the second refrigerant circulating in the second refrigerant circulation passage 721 is insufficient, the second refrigerant is replenished from the second reserve tank 724b.

### 1-3. Overview of Configuration of Housing

Next, an overview of a configuration of the housing 10 included in the fuel cell system 1 will be described.

As illustrated in FIGS. 1A and 1B, the housing 10 includes a lower frame 11. The lower frame 11 has a rectangular frame shape whose longitudinal direction corresponds to the left-right direction, and constitutes a base portion of the housing 10. Although not illustrated, a plurality of reinforcing frames that extend in the front-rear direction and bridge a front portion and a rear portion of the lower frame 11 are attached to the lower frame 11. The plurality of reinforcing frames are arranged at intervals in the left-right direction.

The housing 10 has four pillars 12. The four pillars 12 include a left front pillar 12a, a right front pillar 12b, a left rear pillar 12c, and a right rear pillar 12d. The individual pillars 12 extend in the up-down direction, and specifically, extend upward from respective four corners of the lower frame 11. The four pillars 12 support an upper surface cover 13 that constitutes an upper surface portion of the housing 10.

The housing 10 has, on a front surface, a pair of front doors 14 having a rectangular shape in a front view. The pair of front doors 14 is disposed at the center in the left-right direction of the front surface of the housing 10 and is disposed symmetrically with respect to a front surface partition frame 15 that extends in the up-down direction. A left end portion of a left front door 14a, which is one of the pair of front doors 14 that is disposed on the left side, is swingably attached to the left front pillar 12a. When a right end portion of the left front door 14a is pulled forward from a closed state (corresponding to the state illustrated in FIG. 1A) in which the left front door 14a covers the inside of the housing 10, the left front door 14a swings about a swing center on a left end side and enters an open state in which the inside of the housing 10 is opened. A right end portion of a right front door 14b, which is the other of the pair of front doors 14 that is disposed on the right side, is swingably attached to the right front pillar 12b. When a left end portion of the right front door 14b is pulled forward from the closed state (corresponding to the state illustrated in FIG. 1A), the right front door 14b swings about a swing center on a right end side and enters the open state.

The front surface of the housing 10 includes, in addition to the pair of front doors 14, a pair of front surface upper covers 16 that is disposed above the pair of front doors 14 and a front surface lower cover 17 that is disposed below the pair of front doors 14.

Each of the pair of front surface upper covers 16 has a rectangular shape in front view. The pair of front surface upper covers 16 is arranged symmetrically with respect to the front surface partition frame 15. Of the pair of front surface upper covers 16, the front surface left upper cover 16a disposed on the left side has a rectangular front surface opening portion 161 on a lower right side. Of the pair of front surface upper covers 16, the front side surface right upper cover 16b disposed on the right side has a rectangular front surface opening portion 161 on a lower left side. A ventilation cover 162 that is composed of a grid-like frame and has air permeability is attached to each of the front surface opening portions 161 for the purpose of preventing entry of foreign matter.

A front surface lower cover 17 is disposed below the front doors 14 and supported by the lower frame 11. The front surface lower cover 17 has a rectangular plate shape that is elongated in the left-right direction in a front view. The front surface lower cover 17 has a plurality of slits 171 (see FIG. 4A described below) that pass through the front surface lower cover 17 in the front-rear direction and extend in the up-down direction. The plurality of slits 171 are arranged at intervals in the left-right direction.

The housing 10 has, on a rear side surface thereof, a pair of rear doors 18 having a rectangular shape in a rear view. The pair of rear doors 18 is arranged symmetrically with respect to a rear surface partition frame 19 that is disposed at a center of the rear surface of the housing 10 in the left-right direction and extends in the up-down direction. A left end portion of a left rear door 18a, which is one of the pair of rear doors 18 and is disposed on the left side, is swingably attached to the left rear pillar 12c. When a right end portion of the left rear door 18a is pulled rearward from a closed state (corresponding to the state illustrated in FIG. 1B) in which the left rear door 18a covers the inside of the housing 10, the left rear door 18a swings about a swing center on a left end portion and enters an open state in which the inside of the housing 10 is opened. A right end portion of the right rear door 18b, which is the other of the pair of rear doors 18 that is disposed on the right side, is swingably attached to the right rear pillar 12d. When a left end portion of the right rear door 18b is pulled rearward from the closed state (corresponding to the state illustrated in FIG. 1B), the right rear door 18b swings about a swing center on a right end portion and enters the open state.

The rear surface of the housing 10 includes, in addition to the pair of rear doors 18, a pair of rear surface upper covers 20 that are disposed above the pair of rear doors 18 and a rear surface lower cover 21 that is disposed below the pair of rear doors 18.

Each of the pair of rear surface upper covers 20 has a rectangular shape in rear view. The pair of rear surface upper covers 20 are arranged symmetrically with respect to the rear surface partition frame 19. A rear surface upper left cover 20a, which is one of the pair of rear surface upper covers 20 that is disposed on the left side, has a rectangular rear surface opening portion 201 on a lower right side. Of the pair of rear surface upper covers 20, a rear surface upper right cover 20b disposed on the right side has a rectangular rear surface opening portion 201 on a lower left side. Ventilation covers 202 each of which is composed of a grid-like frame and has air permeability are attached to the respective rear surface opening portions 201 for the purpose of preventing entry of foreign matter.

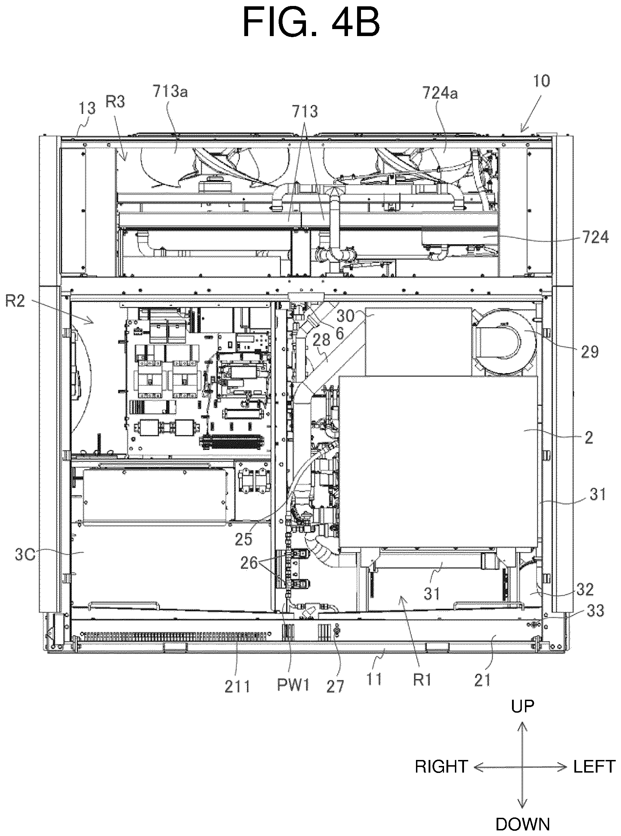

The rear surface lower cover 21 is disposed below the rear doors 18 and is supported by the lower frame 11. The rear surface lower cover 21 has a rectangular shape that is elongated in the left-right direction in rear view. The rear surface lower cover 21 includes a plurality of slits 211 (see FIG. 4B described below) that pass through the rear surface lower cover 21 in the front-rear direction and extend in the up-down direction. The plurality of slits 211 are arranged at intervals in the left-right direction.

The housing 10 further includes a left surface cover 22 provided on the left surface and a right surface cover 23 provided on the right surface. The left surface cover 22 is supported by the left front pillar 12a and the left rear pillar 12c. The right surface cover 23 is supported by the right front pillar 12b and the right rear pillar 12d. Note that, as illustrated in FIG. 1B, the left surface cover 22 has a plurality of left surface openings 221 that penetrate the left surface cover 22 in the left-right direction and extend in the front-rear direction. The plurality of left surface openings 221 are arranged at intervals in the up-down direction.

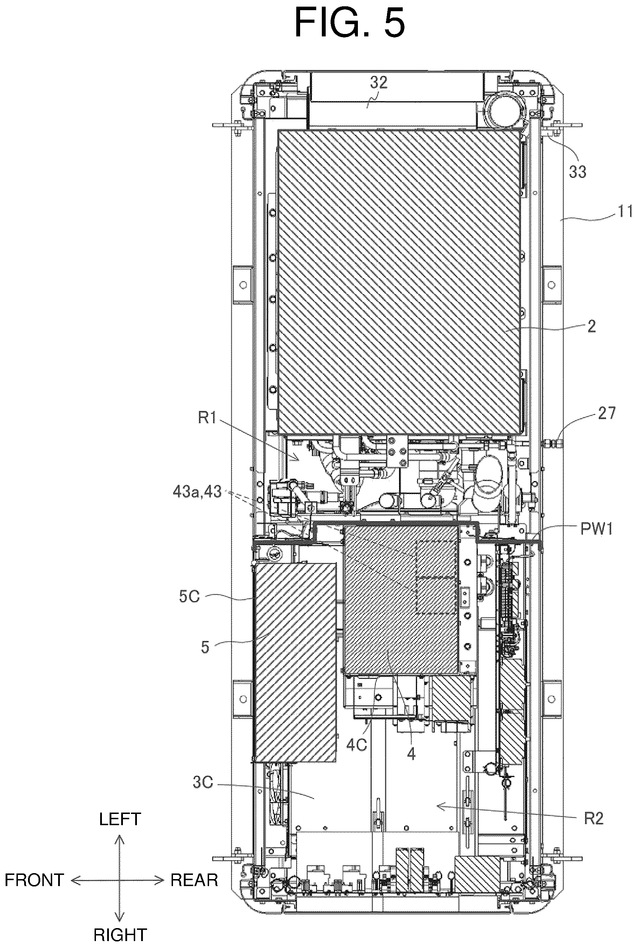

FIG. 4A is a front view schematically illustrating a configuration of the inside of the housing 10. FIG. 4B is a rear view schematically illustrating a configuration of the inside of the housing 10. FIGS. 4A and 4B are diagrams in a case where the pair of front doors 14, the front surface partition frame 15, the pair of front surface upper covers 16, the pair of rear doors 18, the rear surface partition frame 19, and the pair of rear surface upper covers 20 are removed from the housing 10 illustrated in FIGS. 1A and 1B. FIG. 5 is a diagram schematically illustrating a configuration of a cross section when the housing 10 illustrated in FIG. 4A is cut at a V-V position.

As illustrated in FIGS. 4A, 4B, and 5, the housing 10 has a fuel cell room R1, an electrical equipment room R2, and a radiator room R3. The fuel cell room R1 and the electrical equipment room R2 are arranged side by side in the left-right direction. Specifically, the fuel cell room R1 is provided on the left side in the housing 10, and the electrical equipment room R2 is provided on the right side in the housing 10. The electrical equipment room R2 is partitioned from the fuel cell room R1. Specifically, the fuel cell room R1 and the electrical equipment room R2 are partitioned by a first partition wall PW1 that is disposed between the fuel cell room R1 and the electrical equipment room R2 in the left-right direction. The radiator room R3 is provided above the fuel cell room R1 and the electrical equipment room R2 that are provided side by side in the left-right direction. That is, the housing 10 has the radiator room R3 above the fuel cell room R1 and the electrical equipment room R2. The radiator room R3 is partitioned from the fuel cell room R1 and the electrical equipment room R2.

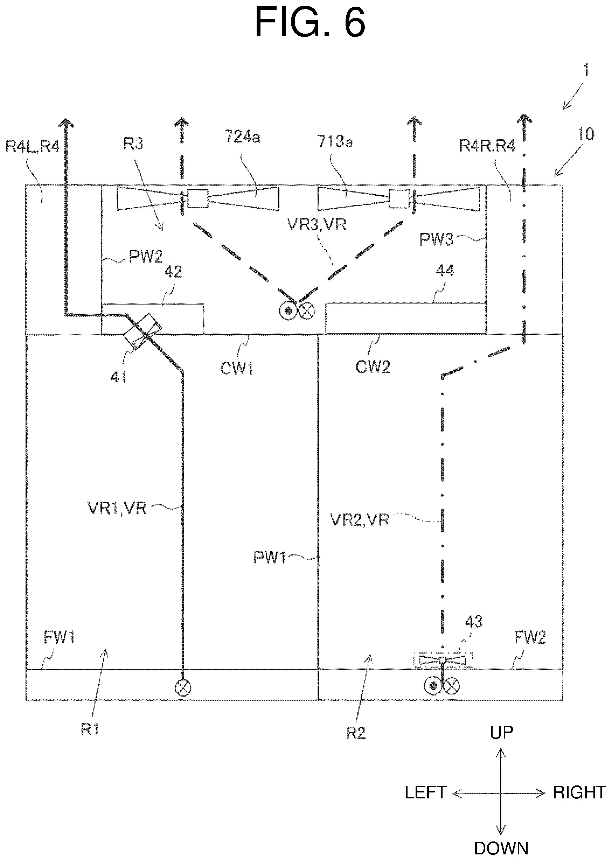

The fuel cell room R1 is a cuboid space. The fuel cell room R1 is a space surrounded by a first floor wall FW1 (see FIG. 6 described below), a first ceiling wall CW1 (see FIG. 6 described below), the first partition wall PW1, the left surface cover 22 (see FIG. 1B), and the front doors 14 (see FIG. 1A) and the rear doors 18 (see FIG. 1B) that are closed. The first floor wall FW1 constitutes a floor surface of the fuel cell room R1. The first ceiling wall CW1 constitutes a ceiling surface of the fuel cell room R1.

The fuel cell module 2 is installed in the fuel cell room R1. The fuel cell module 2 is supported by the first floor wall FW1. Furthermore, the fuel cell room R1 includes a hydrogen supply system, an air supply system, and an exhaust gas system.

The hydrogen supply system includes a hydrogen supply pipe 25 and a shut-off valve 26. The hydrogen supply pipe 25 constitutes a hydrogen supply passage from a hydrogen adapter 27 (refer to FIG. 4B and the like) to the fuel cell stack 2a (refer to FIG. 2). Note that the hydrogen adapter 27 protrudes forward from the rear surface lower cover 21 and is connected to an external pipe (not illustrated) for supplying hydrogen that is disposed outside the housing 10. The shut-off valve 26 is disposed at an intermediate position of the hydrogen supply passage and can shut off the hydrogen supply from the outside. Note that the hydrogen adapter 27 may protrude leftward from a left surface lower cover 22U (refer to FIG. 1B). The left surface lower cover 22U is a side surface cover disposed below the left surface cover 22.

The air supply system includes an air supply pipe 28, an air cleaner 29, and an air filter 30. The air supply pipe 28 constitutes an air supply passage from the left surface opening 221 formed in the left surface cover 22 to the compressor 2c (see FIG. 2). The air cleaner 29 and the air filter 30 are disposed at intermediate positions of the air supply passage and purify the air taken in from the outside of the housing 10.

The exhaust gas system includes an exhaust pipe 31, a silencer 32, and a drain water pipe 33. The exhaust pipe 31 constitutes an exhaust gas route from the fuel cell stack 2a (see FIG. 2) to an exhaust gas outlet 131 (see FIG. 1A and the like) provided in the upper surface cover 13. Note that, specifically, a portion of the exhaust pipe 31 is disposed in a room different from the fuel cell room R1. The silencer 32 is disposed at an intermediate position of the exhaust gas route. The silencer 32 suppresses exhaust noise and separates a portion of moisture contained in exhaust gas from the exhaust gas. The moisture separated from the exhaust gas is discharged as drain water to the outside of the housing 10 via the drain water pipe 33. Note that, as illustrated in FIG. 4B and the like, an outlet-side portion of the drain water pipe 33 extends rearward from a left end portion of the rear surface lower cover 21.

In addition, some components of the first cooling system 71 and the second cooling system 72 described above are arranged in the fuel cell room R1. As illustrated in FIG. 4B, the above-described gas detector 6 is disposed in an upper portion of the fuel cell room R1 near the ceiling wall CW1. In other words, the above-described gas detector 6 is disposed in a space on the ceiling wall CW1 side in the fuel cell room R1. More specifically, the gas detector 6 is disposed above a position where the hydrogen supply pipe 25 is disposed. Since the gas detector 6 is disposed at such a position, the occurrence of leakage of hydrogen gas whose mass is light and which easily rises can be quickly detected. Therefore, when leakage of hydrogen gas occurs, an emergency stop or the like of the system can be quickly executed.

The electrical equipment room R2 is a cuboid space. The electrical equipment room R2 is a space surrounded by a second floor wall FW2 (see FIG. 6 described below), a second ceiling wall CW2 (see FIG. 6 described below), the first partition wall PW1, the right surface cover 23 (see FIG. 1A), and the right front door 14b (see FIG. 1A) and the right rear door 18b (see in FIG. 1B) that are in a closed state. Note that the second floor wall FW2 constitutes a floor surface of the electrical equipment room R2. The second ceiling wall CW2 constitutes a ceiling surface of the electrical equipment room R2.

The electrical equipment room R2 includes a plurality of electrical devices. The plurality of electrical devices include, for example, the battery 3 and the inverter 4 that are electrically connected to the fuel cell module 2. Note that the battery 3 is disposed in the electrical equipment room R2 in a state of being accommodated in a battery case 3C. Specifically, the number of batteries 3 accommodated in the battery case 3C is two or more. The inverter 4 is disposed in the electrical equipment room R2 in a state of being accommodated in an inverter case 4C. Note that a plurality of electrical devices are collectively installed in the electrical equipment room R2, and a large number of other electrical components, such as the batteries 3 and the inverter 4, are also installed in the electrical equipment room R2. For example, the control device 5 (refer to FIG. 2) is disposed in the electrical equipment room R2 in a state of being accommodated in a controller case 5C. The electrical equipment room R2 also includes a relay, a breaker, a converter, and the like.

The radiator room R3 is a cuboid space extending in the left-right direction. The radiator room R3 is provided between the upper surface cover 13 and each of the first ceiling wall CW1 and the second ceiling wall CW2 (see FIG. 6 described below). In other words, the housing 10 has the radiator room R3 above the ceiling wall CW1 constituting the fuel cell room R1. Furthermore, the housing 10 has the radiator room R3 above the ceiling wall CW2 constituting the electrical equipment room R2.

The radiator room R3 accommodates a radiator that cools the fuel cell module 2. In this embodiment, the radiator is the first heat exchanger 713 and the second heat exchanger 724 described above. Specifically, the two first heat exchangers 713 are installed in the radiator room R3. The two first heat exchangers 713 are arranged side by side in the left-right direction. In this embodiment, the two first heat exchangers 713 are arranged in parallel in the first cooling system 71, but may be arranged in series. On the other hand, the number of second heat exchangers 724 disposed in the radiator room R3 is one. The second heat exchanger 724 is disposed below one of the two first heat exchangers 713 arranged in the left-right direction. To be specific, the second heat exchanger 724 is disposed below the first heat exchanger 713 disposed on the left side out of the two first heat exchangers 713. Note that the number and arrangement of the first heat exchangers 713 and the second heat exchangers 724 may be changed as appropriate.

Among the components of the first cooling system 71 and the second cooling system 72 described above, at least some of the components that are not installed in the fuel cell room R1 are disposed in the radiator room R3. In the radiator room R3, in addition to the first heat exchanger 713 and the second heat exchanger 724, for example, the first radiator fan 713a and the second radiator fan 724a described above are arranged. The first radiator fan 713a is installed above the first heat exchanger 713 disposed on the right side. The second radiator fan 724a is installed above the first heat exchanger 713 disposed on the left side. With such a configuration, the second radiator fan 724a is disposed for sending air to the second heat exchanger 724, and specifically, is also used for sending air to the first heat exchanger 713 disposed on the left side.

Note that the upper surface cover 13 disposed above the first radiator fan 713a and the second radiator fan 724a has fan opening portions 132 at positions facing the radiator fans 713a and 724a in the up-down direction (see FIG. 1A and the like). Furthermore, a ventilation cover 133 that is configured using a radial frame and has air permeability is attached to each of the fan opening portions 132 for preventing entry of foreign matter.

### 2. Ventilation Structure

Next, the ventilation structure provided in the fuel cell system 1 configured as described above will be described in detail. The fuel cell system 1 includes a ventilation structure for ventilating the housing 10. By ventilating the housing 10, for example, the hydrogen concentration in the housing 10 can be easily kept low. For example, by ventilating the housing 10, it is possible to prevent heat from accumulating in the housing 10.

### 2-1. Overview

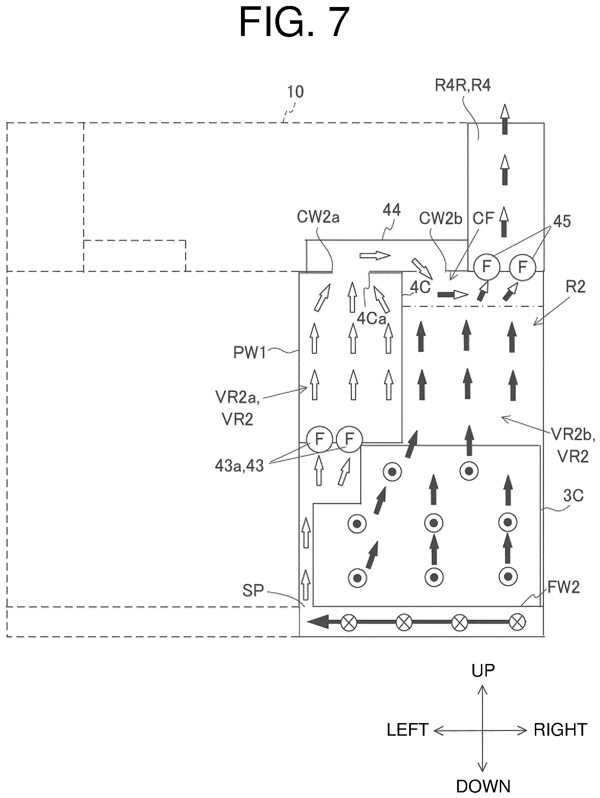

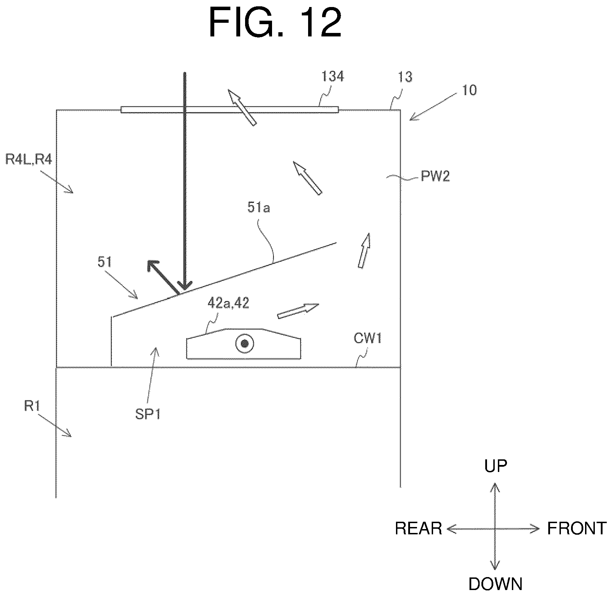

FIG. 6 is a diagram schematically illustrating an outline of the ventilation structure included in the fuel cell system 1 according to the embodiment of the present invention. In FIG. 6, an arrow of a thick solid line, an arrow of a dashed-dotted line, and an arrow of a broken line indicate ventilation routes VR. Directions of the arrows indicate directions in which the ventilation flow (air) flows in the ventilation routes VR. Note that, in FIG. 6, a symbol with a black circle in a circle indicates an arrow from a back side to a front side of a paper surface, and a symbol with a cross mark in a circle indicates an arrow from the front side to the back side of the paper surface. The same applies to FIGS. 7 and 12 to be described below.

As illustrated in FIG. 6, the housing 10 has the ventilation routes VR through which the housing 10 is ventilated. Inlets of the ventilation routes VR are provided on a side surface of the housing 10. Outlets of the ventilation routes VR are provided on an upper surface of the housing 10. That is, in the fuel cell system 1, during ventilation, intake is performed on the side surface of the housing 10, and exhaust is performed on the upper surface of the housing 10.

With such a configuration, since the intake and the exhaust are performed at positions separated from each other in the housing 10, occurrence of a short circuit in the own system can be suppressed. Since the exhaust is performed on the upper surface of the housing 10, when a plurality of fuel cell systems 1 are arranged side by side, it is possible to easily avoid the occurrence of a short circuit between the adjacent fuel cell systems. The short circuit refers to a phenomenon in which positions of an inlet (air supply port) and an outlet (air exhaust port) of ventilation are too close to each other and air circulates in a narrow range.

The inlets of the ventilation routes VR are preferably provided in a lower portion of the side surface of the housing 10. Thus, the outlets of the ventilation routes VR provided on the upper surface of the housing 10 and the inlets of the ventilation routes VR can be arranged at positions separated from each other as much as possible. Thus, a short circuit can be less likely to occur in the own system or the like. Note that, in this embodiment, the slits 171 and 211 (refer to FIGS. 4A and 4B) provided in the lower portion of the side surface of the housing 10 described above are used as the inlets of the ventilation routes VR. Details of this will be described later.

Specifically, the plurality of ventilation routes VR are provided in the housing 10. The housing 10 includes a fuel cell room ventilation route VR1, an electrical equipment room ventilation route VR2, and a radiator room ventilation route VR3.

The fuel cell room ventilation route VR1 is a route for ventilating the fuel cell room R1. The fuel cell room ventilation route VR1 has an inlet of the ventilation route in a lower portion of the side surface of the housing 10. Specifically, the inlet corresponds to the plurality of slits 171 (see FIG. 4A) provided in the lower left portion of the front surface of the housing 10. The fuel cell room ventilation route VR1 has an outlet of the ventilation route on the upper surface of the housing 10. The outlet corresponds to upper surface left opening portions 134 (see FIG. 1A and the like) provided in a left end portion of the upper surface cover 13. Note that the upper surface left opening portions 134 are specifically configured by an aggregate of a plurality of slits having a small size and extending in the front-rear direction for preventing entry of foreign matter. The plurality of slits constituting the upper surface left opening portion 134 are arranged in the front-rear and left-right directions. Although the number of the upper surface opening portions 134 is two in this embodiment, the number may be changed as appropriate, and may be one or three or more. The fuel cell room ventilation route VR1 includes the fuel cell room R1 between the inlet and the outlet, and thus enables the fuel cell room R1 to be ventilated.

The fuel cell room R1 has a downstream ventilation fan 41 that is disposed at a position on a downstream of a ventilation flow flowing through the fuel cell room ventilation route VR1 in the fuel cell room R1. The downstream ventilation fan 41 is driven to generate a ventilation flow that is a flow of air in the fuel cell room ventilation route VR1. Note that the downstream ventilation fan 41 is disposed in an opening portion provided in the ceiling wall CW1 (first ceiling wall) that constitutes the ceiling surface of the fuel cell room R1. The downstream ventilation fan 41 is an electric fan, and is preferably an explosion-proof electric fan. The downstream ventilation fan 41 is specifically an axial fan.

Here, the flow of the ventilation air (ventilation flow) generated by the driving of the downstream ventilation fan 41 will be described. When the downstream ventilation fan 41 is driven, air enters a lower portion of the housing 10 from the outside of the housing 10 via the inlet constituted by the plurality of slits 171. The air that has entered the lower portion of the housing 10 enters the fuel cell room R1 through a ventilation portion provided in the floor wall (first floor wall) FW1 of the fuel cell room R1. In this embodiment, the ventilation portion provided in the floor wall FW1 of the fuel cell room R1 is obtained by constituting at least a portion of the first floor wall FW1 with a mesh-like member. However, such a configuration is merely an example, and for example, at least one opening portion may be provided in the first floor wall FW1, and the opening portion may be used as a ventilation portion.

The air that has entered the fuel cell room R1 flows from a lower side to an upper side of the fuel cell room R1, passes through the downstream ventilation fan 41, and exits the fuel cell room R1. The air that has flowed out of the fuel cell room R1 enters a left duct room R4L provided on the left side of the radiator room R3 via a fuel cell room upper duct 42 disposed on the upper side of the first ceiling wall CW1. The air that has entered the left duct room R4L rises in the left duct room R4L and is discharged to the outside of the housing 10 via the outlet formed by the upper surface left opening portions 134.

Note that the fuel cell room upper duct 42 is provided in the radiator room R3. Furthermore, the left duct room R4L and the fuel cell room R1 are partitioned by the first ceiling wall CW1. The left duct room R4L and the radiator room R3 are partitioned by a second partition wall PW2.

As can be seen from the above description, the fuel cell room R1 includes the floor wall FW1 having the ventilation portion through which the airflow from the inlet of the fuel cell room ventilation route VR1 passes and the ceiling wall CW1 in which the downstream ventilation fan 41 is disposed. With this configuration, in the fuel cell room R1, the flow of air during ventilation is set from the lower side to the upper side, and the hydrogen gas can be efficiently discharged from the room.

Note that the ceiling surface of the fuel cell room R1 constituted by the ceiling wall (first ceiling wall) CW1 is preferably a flat surface that extends horizontally. For example, when a recessed portion (recess) is provided in the ceiling surface, hydrogen gas is more likely to stay in the portion. By providing the ceiling surface in a flat shape, the possibility of hydrogen gas staying in the ceiling surface of the fuel cell room R1 can be reduced.

Furthermore, the downstream ventilation fan 41 is preferably disposed with a rotation shaft inclined with respect to the up-down direction. With this configuration, components in the left-right direction can be applied to the airflow exiting from the fuel cell room R1. As a result, the outlet of the ventilation flow can be set at a position deviated from the upper surface of the radiator room R3 provided above the fuel cell room R1. In this embodiment, the rotation shaft of the downstream ventilation fan 41 is inclined to the left side toward the upper side. That is, the rotation shaft of the downstream ventilation fan 41 is inclined so as to approach the left duct room R4L as it goes upward. Thus, the air coming out of the fuel cell room R1 can be efficiently guided to the left duct room R4L.

The electrical equipment room ventilation route VR2 is a route for ventilating the electrical equipment room R2. Note that the electrical equipment room ventilation route VR2 of this embodiment is simplified in FIG. 6. This simplified configuration will be described in the description of the electrical equipment room ventilation route VR2 with reference to FIG. 6. The configuration that is not simplified will be separately described below.

The electrical equipment room ventilation route VR2 has an inlet of the ventilation route in the lower portion of the side surface of the housing 10. Specifically, the inlet corresponds to the plurality of slits 171 and 211 (see FIGS. 4A and 4B) provided on the front surface and in a lower right portion of the rear surface of the housing 10. The electrical equipment room ventilation route VR2 has an outlet of the ventilation route on the upper surface of the housing 10. The outlet corresponds to an upper surface right opening portion 135 (see FIG. 1A) provided in a right end portion of the upper surface cover 13. Note that the upper surface right opening portion 135 is specifically configured by an aggregate of a plurality of slits having a small size and extending in the front-rear direction for preventing entry of foreign matter. The plurality of slits constituting the upper surface right opening portion 135 are arranged in the front-rear and left-right directions. The electrical equipment room ventilation route VR2 has the electrical equipment room R2 between the inlet and the outlet, thereby enabling the electrical equipment room R2 to be ventilated.

In the fuel cell system 1 of this embodiment, the ventilation route provided in the housing 10 is divided into the ventilation route VR1 for the fuel cell room R1 and the ventilation route VR2 for the electrical equipment room R2. With such a configuration, the ventilation configuration can be made different between the fuel cell room R1 and the electrical equipment room R2. As a result, a difference in air pressure can be generated between the fuel cell room R1 and the electrical equipment room R2. The air pressure difference can be used to prevent generation of an air flow from the fuel cell room R1, through which hydrogen gas may leak, toward the electrical equipment room R2. That is, even if the hydrogen gas leaks in the fuel cell room R1, the hydrogen gas can be prevented from flowing into the electrical equipment room R2 in which the electrical devices serving as ignition sources are intensively disposed, and the hydrogen gas concentration in the electrical equipment room R2 can be prevented from increasing.

The electrical equipment room R2 has an upstream ventilation fan 43 that is disposed at a position on the upstream of a ventilation flow flowing through the electrical equipment room ventilation route VR2 in the electrical equipment room R2. The upstream ventilation fan 43 is driven to generate a ventilation flow that is a flow of air in the electrical equipment room ventilation route VR2. Note that the upstream ventilation fan 43 is an electric fan. The upstream ventilation fan 43 is specifically an axial fan. The detailed arrangement of the upstream ventilation fan 43 will be described below.

Here, the flow of ventilation air (airflow) generated by the driving of the upstream ventilation fan 43 will be described. When the upstream ventilation fan 43 is driven, air enters the lower portion of the housing 10 from the outside of the housing 10 via the inlet constituted by the plurality of slits 171 and 211. The air that has entered the lower portion of the housing 10 enters the electrical equipment room R2 through a ventilation portion provided in the floor wall (second floor wall) FW2 of the electrical equipment room R2. The ventilation portion provided in the second floor wall FW2 will be described in detail below.

The air that has entered the electrical equipment room R2 flows from the lower side to the upper side of the electrical equipment room R2 and exits the electrical equipment room R2 through an opening portion (not illustrated) provided in the ceiling wall (second ceiling wall) CW2 of the electrical equipment room R2. The air having flowed out of the electrical equipment room R2 enters a right duct room R4R provided on the right side of the radiator room R3. The air that has entered the right duct room R4R rises in the right duct room R4R and is discharged to the outside of the housing 10 via the outlet formed by the upper surface right opening portion 135.

The right duct room R4R and the electrical equipment room R2 are partitioned by the second ceiling wall CW2. The right duct room R4R and the radiator room R3 are partitioned by a third partition wall PW3.

As can be seen from the above description, in this embodiment, the duct rooms are separately provided for the fuel cell room R1 and the electrical equipment room R2. In other words, the fuel cell system 1 has the duct room R4L provided for the fuel cell room R1 and the duct room R4R provided for the electrical equipment room R2. Thus, the different ventilation routes can be easily provided for the fuel cell room R1 and the electrical equipment room R2. In this embodiment, the duct room R4L for the fuel cell room R1 and the duct room R4R for the electrical equipment room R2 are provided so as to sandwich the radiator room R3. In other words, the radiator room R3 is provided between the duct room R4L provided for the fuel cell room R1 and the duct room R4R provided for the electrical equipment room R2. With this configuration, the plurality of ventilation routes can be efficiently provided in the housing 10 including the fuel cell room R1, the electrical equipment room R2, and the radiator room R3.

Note that, unlike the configuration of this embodiment, the exhaust of the ventilation of the fuel cell room R1 and the electrical equipment room R2 may be collectively performed from the radiator room R3. However, with such a configuration, there is a concern that the cooling capacity of the radiator (the first heat exchanger 713 or the second heat exchanger 724) will decrease. Therefore, as in this embodiment, the duct rooms R4 are preferably provided for the fuel cell room R1 and the electrical equipment room R2.

In the above-described fuel cell room R1, the ventilation fan (the downstream ventilation fan 41) that generates an airflow for ventilation is disposed in a portion where air exits the room. Thus, the fuel cell room R1 can have a negative pressure when the downstream ventilation fan 41 is driven. On the other hand, in the electrical equipment room R2, the ventilation fan (the upstream ventilation fan 43) that generates an airflow for ventilation is disposed in a portion where air enters the room or near the portion. Therefore, the electrical equipment room R2 can have a positive pressure when the upstream ventilation fan 43 is driven.

That is, the fuel cell system 1 of this embodiment is configured such that, when the fuel cell module 2 is in operation, the downstream ventilation fan 41 and the upstream ventilation fan 43 are in operation and air pressure in the electrical equipment room R2 is higher than air pressure in the fuel cell room R1. Thus, even if the hydrogen gas leaks in the fuel cell room R1, the hydrogen gas can be prevented from flowing into the electrical equipment room R2 in which the electrical devices serving as ignition sources are arranged in a concentrated manner. That is, the hydrogen gas concentration in the electrical equipment room R2 can be prevented from becoming high. Note that this embodiment has a configuration in which the downstream ventilation fan 41 and the upstream ventilation fan 43 are operated during the operation of the fuel cell module 2 so that the air pressure of the electrical equipment room R2 is higher than the air pressure of the fuel cell room R1. However, this is an example, and for the same purpose, at least one of the downstream ventilation fan 41 and the upstream ventilation fan 43 may be configured to operate.

The radiator room ventilation route VR3 is a route for ventilating the radiator room R3. The radiator room ventilation route VR3 has inlets of the ventilation route in the upper portion of the side surface of the housing 10. Specifically, the inlets correspond to the front surface opening portions 161 (see FIG. 1A) provided in the pair of front surface upper covers 16 and the rear surface opening portions 201 (see FIG. 1B) provided in the pair of rear surface upper covers 20. The radiator room ventilation route VR3 has outlets of the ventilation route on the upper surface of the housing 10. The outlets correspond to the two fan opening portions 132 (see FIG. 1A and the like) provided in a central portion of the upper surface cover 13. The radiator room ventilation route VR3 has the radiator room R3 between the inlets and the outlets, thereby enabling ventilation of the radiator room R3.

Ventilation of the radiator room R3 can be performed by driving the two radiator fans 713a and the 724a. Here, a flow of the ventilation air (airflow) generated by the driving of the radiator fans 713a and 724a will be described. When the radiator fans 713a and 724a are driven, air enters the radiator room R3 from the outside of the housing 10 via the inlets formed by the front surface opening portions 161 and the rear surface opening portions 201. The air that has entered the radiator room R3 rises while exchanging heat with refrigerant flowing inside the first heat exchanger 713 and the second heat exchanger 724. Then, the raised air is exhausted to the outside of the housing 10 via the outlets formed by the fan opening portions 132.

### 2-2. Details of Electrical Equipment Room Ventilation Route

The detailed configuration of the electrical equipment room ventilation route VR2 whose outline has been described above will be described.

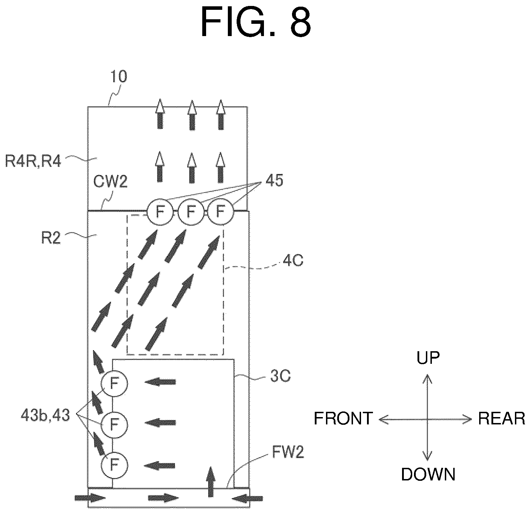

FIG. 7 is a schematic front view for explaining the details of the electrical equipment room ventilation route VR2. FIG. 8 is a right side schematic view for explaining the details of the electrical equipment room ventilation route VR2. In FIGS. 7 and 8, thick arrows indicate a flow of the airflow during ventilation (ventilation flow). The arrows include a plurality of types of arrow forms intended to indicate differences in types of ventilation route through which the ventilation flow passes.

As illustrated in FIGS. 7 and 8, the electrical equipment room R2 has a plurality of ventilation routes. That is, the above-described electrical equipment room ventilation route VR2 includes a plurality of ventilation routes. In the electrical equipment room R2, since an electrical device that generates heat during operation and a plurality of electrical devices having different temperature requirements during use need to be disposed in a limited space, it is usually difficult to achieve an appropriate heat balance as a thermal design. In this regard, since this embodiment has a configuration in which the plurality of ventilation routes are provided in the electrical equipment room R2, the heat balance can be easily optimized.

In this embodiment, the plurality of ventilation routes include an inverter ventilation route VR2a and a battery ventilation route VR2b. The inverter ventilation route VR2a ventilates the inverter case 4C that accommodates the inverter 4. The battery ventilation route VR2b ventilates the battery case 3C that accommodates the batteries 3.

Note that, specifically, the inverter case 4C houses inverter components constituting an inverter circuit. The inverter case 4C may be configured by using a portion of the first partition wall PW1 and a portion of the second ceiling wall CW2, or may be configured without using such a portion. Specifically, the battery case 3C houses the plurality of batteries 3. The battery case 3C may have, for example, a bottomed box shape having an opening on a lower surface, and may have a bottom wall.

Among the electrical devices disposed in the electrical equipment room R2, the battery 3 and the inverter 4 generate a large amount of heat. In this embodiment, since the ventilation routes for the battery 3 and the inverter 4, which generate a large amount of heat, are separately and independently provided, the heat balance in the electrical equipment room R2 can be easily optimized.

The types and the number of ventilation routes included in the plurality of ventilation routes in the configuration of this embodiment may be changed as appropriate.

The fuel cell system 1 includes inverter ventilation fans 43a that are disposed in the inverter ventilation route VR2a and battery ventilation fans 43b that are disposed in the battery ventilation route VR2b. Since the ventilation fans are separately disposed in the respective ventilation routes VR2a and VR2b, flow rates during ventilation in the respective ventilation routes VR2a and VR2b can be easily secured.

Note that the inverter ventilation fans 43a and the battery ventilation fans 43b are included in the above-described upstream ventilation fan 43. That is, the inverter ventilation fans 43a and the battery ventilation fans 43b are disposed at positions on the upstream side of the ventilation flow in the electrical equipment room R2.

Specifically, the inverter ventilation fans 43a are disposed at a position on the upstream of the inverter 4 in the inverter ventilation route VR2a. More specifically, the inverter ventilation fans 43a are disposed in an opening portion provided in a lower surface of the inverter case 4C. With this configuration, the air blown out from the inverter ventilation fans 43a can be first applied to the inverter components. As described above, the inverter ventilation fans 43a are disposed at positions on the upstream of the ventilation flow in the electrical equipment room R2. Thus, by driving the inverter ventilation fans 43a, cold air that has not been warmed by the other electrical devices can be applied to the inverter components.

Here, the ventilation flow in the inverter ventilation route VR2a generated by the driving of the inverter ventilation fans 43a will be described. When the inverter ventilation fans 43a are driven, air enters the lower portion of the housing 10 from the outside of the housing 10 via the ventilation inlets constituted by the plurality of slits 171 and 211. The air that has entered the lower portion of the housing 10 enters the inverter case 4C via a gap SP formed between the floor wall (second floor wall) FW2 of the electrical equipment room R2 and the first partition wall PW1, and the inverter ventilation fans 43a. Note that a filter for removing foreign matter is preferably disposed on the upstream of the inverter ventilation fans 43a (the upstream of the ventilation flow).

The air that has entered the inverter case 4C flows from the lower side to the upper side of the inverter case 4C and exits the electrical equipment room R2 through an opening 4Ca formed in the ceiling portion of the inverter case 4C and a first opening CW2a formed in the ceiling wall (second ceiling wall) CW2 of the electrical equipment room R2. The air having flowed out of the electrical equipment room R2 enters an electrical equipment room upper duct 44 provided on the upper side of the second ceiling wall CW2. Note that the electrical equipment room upper duct 44 is disposed in the radiator room R3. The air that has entered the electrical equipment room upper duct 44 returns to the electrical equipment room R2 via the second opening CW2b provided at a position on the second ceiling wall CW2 on the right side of the inverter case 4C. The air returned into the electrical equipment room R2 merges with the air flowing through the battery ventilation route VR2b. The flow of the ventilation flow after the merging will be described after the battery ventilation route VR2b is described.

The battery ventilation fans 43b are disposed on the downstream of the ventilation flow with respect to the batteries 3 in the battery ventilation route VR2b. The battery ventilation fans 43b may be disposed on the upstream of the batteries 3 in the ventilation flow. However, with the configuration of this embodiment, the ventilation flow can be evenly applied to the plurality of batteries 3 arranged in the battery case 3C.

To be specific, the plurality of battery ventilation fans 43b are disposed on the front surface of the battery case 3C (see FIGS. 4A and 8). Each of the battery ventilation fans 43b is disposed in an opening portion formed in the front surface of the battery case 3C. The arrangement of the plurality of battery ventilation fans 43b is determined in accordance with the arrangement of the plurality of batteries 3 in the battery case 3C.

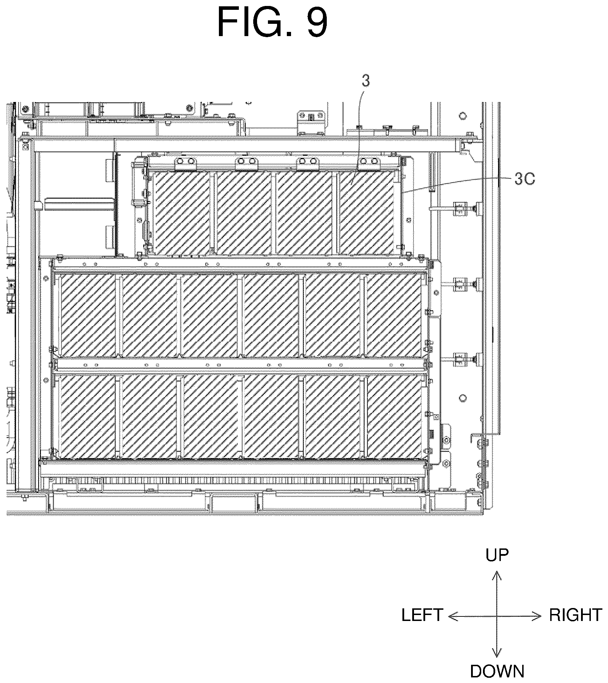

FIG. 9 is a cross-sectional view schematically illustrating the arrangement of the batteries 3 in the battery case 3C. As illustrated in FIG. 9, the plurality of batteries 3 are separately arranged in three stages, that is, an upper stage, a middle stage, and a lower stage. In the upper stage, the four batteries 3 are arranged in the left-right direction. The six batteries 3 are arranged in the left-right direction in each of the middle stage and the lower stage. When positions of the batteries 3 arranged in the middle row are compared with positions of the batteries 3 arranged in the lower row, the plurality of batteries 3 are arranged in the left-right direction in the same positions in the left-right direction. That is, each of the batteries 3 in the middle row is arranged in the up-down direction at the same position in the left-right direction as a corresponding one of the batteries 3 in the lower row. The batteries 3 in the upper stage are arranged at positions shifted from the batteries 3 in the middle stage in the left-right direction.

The plurality of battery ventilation fans 43b are separately arranged in an upper portion, a central portion, and a lower portion of the front surface of the battery case 3C so as to correspond to the plurality of batteries 3 arranged in the battery case 3C. The two battery ventilation fans 43b are arranged at an interval in the left-right direction in an upper portion of the front surface of the battery case 3C. The three battery ventilation fans 43b are arranged at intervals in the left-right direction in a front central portion and a front lower portion of the battery case 3C. The arrangements and the numbers of the batteries 3 and the battery ventilation fans 43b described above are examples and may be changed as appropriate.

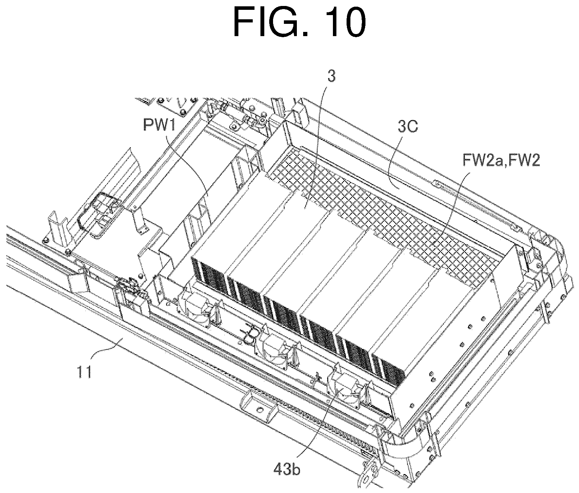

Here, the ventilation flow in the battery ventilation route VR2b generated by the driving of the battery ventilation fans 43b will be described. When the plurality of battery ventilation fans 43b are driven, air enters the lower portion of the housing 10 from the outside of the housing 10 via the ventilation inlets constituted by the plurality of slits 171 and 211. The air that has entered the lower portion of the housing 10 passes through a ventilation portion provided in the floor wall (second floor wall) of the electrical equipment room R2 and enters the battery case 3C. This will be described in more detail with reference to FIG. 10.

FIG. 10 is a cross-sectional perspective view illustrating a schematic configuration of a cross section taken at an X-X position in FIG. 4A. As shown in FIG. 10, the plurality of batteries 3 are arranged closer to the front in the battery case 3C. Therefore, a rear portion of the second floor wall FW2 covered with the battery case 3C is opened in the battery case 3C without the batteries 3 being disposed thereon. An open portion FW2a of the second floor wall FW2 is composed of a mesh-like member. In the battery ventilation route VR2b, the open portion FW2a composed of a mesh-like member serves as a ventilation portion, and air that has entered the lower portion of the housing 10 from the outside of the housing 10 can be taken into the battery case 3C.

The air that has entered the battery case 3C flows from the rear toward the front in the battery case 3C while hitting the batteries 3, and exits to the front outside of the battery case 3C via the plurality of battery ventilation fans 43b. Note that the plurality of batteries 3 are arranged at intervals in the battery case 3C. Thus, the air flowing from the rear to the front in the battery case 3C can be applied to the individual batteries 3. In this embodiment, the installation interval between the batteries 3 is adjusted such that the balance between a pressure loss and a flow rate of ventilation is optimized. As a result, a heat dissipation capacity in the ventilation route using the plurality of battery ventilation fans 43b is improved.

The air that has flowed out in front of the battery case 3C first passes between the battery case 3C and the right front door 14b in the front-rear direction and rises in the electrical equipment room R2. Then, when the air that has flowed out to the front of the battery case 3C flows out to a position higher than the battery case 3C, the air also uses a space above the battery case 3C as a ventilation route and flows toward the upper portion of the electrical equipment room R2.

In the battery ventilation route VR2b, the ventilation flow first hits the batteries 3 among the electrical devices arranged in the ventilation route. That is, the ventilation flow first hits the batteries 3, which are the electrical devices that are most desired to be cooled. Then, the ventilation flow hits the batteries 3 and then hits the various electrical devices and the cases that accommodate the electrical devices, and contributes to cooling of these devices.

For example, the ventilation flow flowing through the battery ventilation route VR2b hits an outer surface of the controller case 5C (refer to FIG. 4A). Furthermore, for example, the ventilation flow flowing through the battery ventilation route VR2b hits the outer surface of the inverter case 4C. That is, the inverter 4 can be cooled not only by the ventilation flow passing through the inside of the inverter case 4C but also by the ventilation flow passing through the outside of the inverter case 4C. In the battery ventilation route VR2b (the same applies to the inverter-ventilation route VR2a), an electrical component having a smaller allowable range of an ambient temperature change is preferably disposed on the upstream of the ventilation route. With this configuration, it is possible to prevent the electrical devices arranged in the electrical equipment room R2 from causing a problem, such as a malfunction.

In the battery ventilation route VR2b, the air that has reached the upper portion of the electrical equipment room R2 merges with the air that has returned into the electrical equipment room R2 from the electrical equipment room upper duct 44 in the inverter ventilation route VR2a. That is, the electrical equipment room R2 has a merging portion CF where the inverter ventilation route VR2a and the battery ventilation route VR2b merge with each other. By providing the merging portion CF, final outlets of the two ventilation routes VR2a and VR2b provided in the electrical equipment room R2 can be combined into one, and an increase in a size of the housing 10 can be suppressed.

In this embodiment, shared ventilation fans 45 (see FIGS. 7 and 8) are arranged at positions on the downstream of the ventilation flow with respect to the merging portion CF. By providing the shared ventilation fans 45, the ventilation flow merged at the merging portion CF can be easily guided to the right duct room R4R. That is, the shared ventilation fans 45 can be said to be assist ventilation fans that assist the flow of the ventilation flow.

Specifically, the plurality of shared ventilation fans 45 are provided. However, the number of the shared ventilation fans 45 may be one, and may be a number as necessary. In this embodiment, two ventilation fan lines each of which includes the three shared ventilation fans 45 arranged in the front-rear direction, are arranged in the left-right direction. That is, the number of the shared ventilation fans 45 is six.

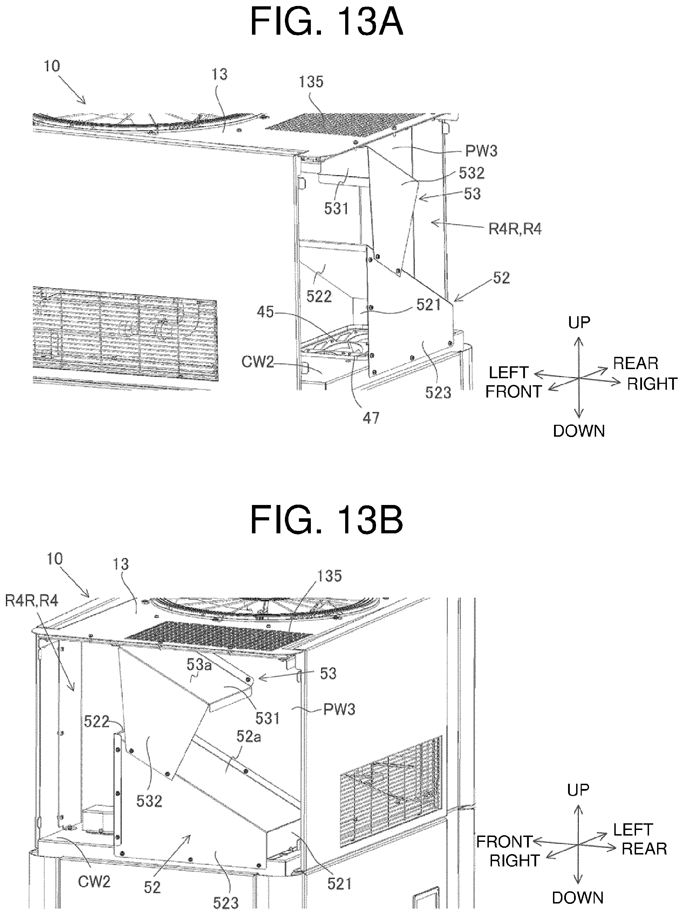

The plurality of shared ventilation fans 45 are provided in an opening portion (a ceiling wall opening portion 47 illustrated in FIG. 13A described below) formed in a right end portion of the ceiling wall (second ceiling wall) CW2 of the electrical equipment room R2. The shared ventilation fans 45 are electric fans of the same type, and are specifically axial fans. The shared ventilation fans 45 are also disposed with rotation shafts inclined with respect to the up-down direction, as with the above-described downstream ventilation fan 41. Specifically, the downstream ventilation fan 41 is disposed with the rotation shaft inclined in the left-right direction, whereas the shared ventilation fans 45 are disposed with the rotation shafts inclined in the front-rear direction.

The air supplied from the two ventilation routes VR2a and VR2b merged at the merging portion CF enters the right duct room R4R via the shared ventilation fans 45. The air that has entered the right duct room R4R rises in the right duct room R4R and is discharged to the outside of the housing 10 via the outlet formed by the upper surface right opening portion 135 (see FIG. 1A and the like).

### 2-3. Structure of Duct Room

In this embodiment, the outlets of the ventilation routes VR1 and VR2 of the fuel cell room R1 and the electrical equipment room R2, respectively, are upper surface opening portions formed in the upper surface of the housing 10. The upper surface opening portions specifically correspond to the upper surface left opening portion 134 and the upper surface right opening portion 135 (refer to FIG. 1A and the like for both). Then the duct room R4 included in the housing 10 is connected to the upper surface left opening portion 134 and the upper surface right opening portion 135 and constitutes portions of the ventilation routes VR1 and VR2. In such a configuration, since the outlets of the ventilation routes are present on the upper surface, a countermeasure against the entry of rainwater into the fuel cell room R1 or the electrical equipment room R2 is required. The duct room R4 of this embodiment includes a structure for preventing rainwater from entering the fuel cell room R1 or the electrical equipment room R2. The rainwater intrusion prevention structure of the duct room R4 will be described below.

As described above, the duct room R4 specifically includes the left duct room R4L and the right duct room R4R. The left duct room R4L and the right duct room R4R have the same basic concept of the rainwater entry prevention structure. However, the left duct room R4L and the right duct room R4R have slightly different structures. In consideration of this point, the structure of the left duct room R4L and the structure of the right duct room R4R will be separately described. Note that the left duct room R4L and the right duct room R4R may have exactly the same structure in some cases.

### 2-3-1. Left Duct Room

First, the left duct room R4L will be described. The left duct room R4L is for the fuel cell room ventilation route VR1.

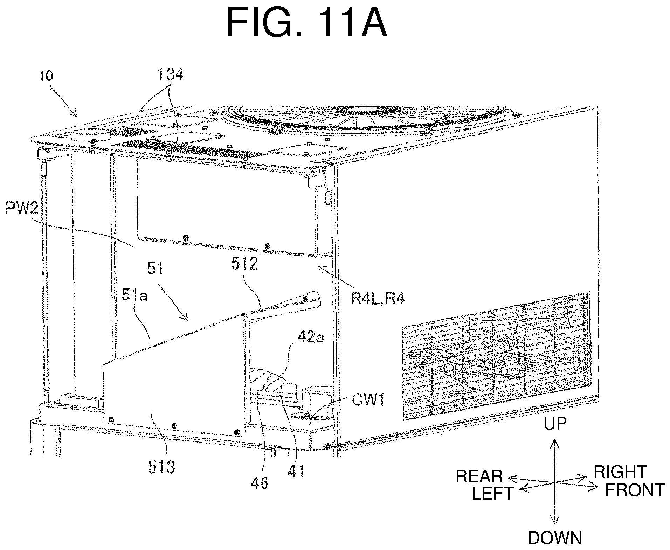

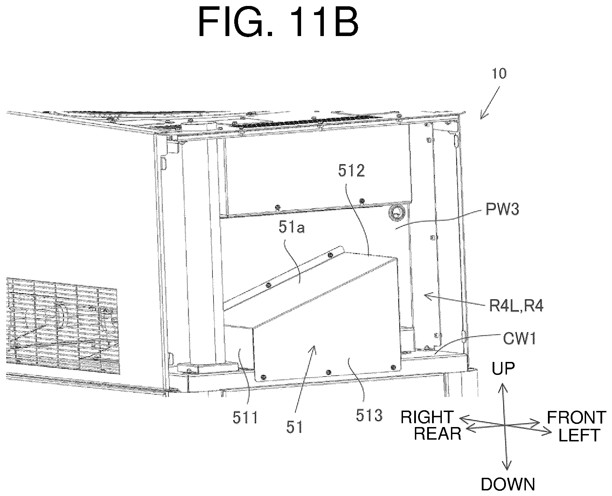

FIG. 11A is a first perspective view for explaining an internal structure of the left duct room R4L. FIG. 11B is a second perspective view for explaining the internal structure of the left duct room R4L. FIG. 12 is a diagram schematically illustrating operation of the left duct room R4L. FIGS. 11A and 11B illustrate a state where some members provided on a left side surface of the left duct room R4L are removed. The direction in which the left duct room R4L is viewed is different between the diagram illustrated in FIG. 11A (first perspective view) and the diagram illustrated in FIG. 11B (second perspective view). Both FIGS. 11A and 11B are diagrams of the left duct room R4L as viewed from a left surface side, but FIG. 11A is a diagram as viewed obliquely from above on the front side, and FIG. 11B is a diagram as viewed obliquely from above on the rear side. Furthermore, white arrows in FIG. 12 indicate directions in which the ventilation flow flows. Thick solid arrows illustrated in FIG. 12 indicate a movement of rainwater.

As illustrated in FIGS. 6, 11A, and 11B, the housing 10 has, below the left duct room R4L, the fuel cell room R1 (room) partitioned from the left duct room R4L by the first ceiling wall CW1. The fuel cell room R1 is connected to the left duct room R4L via the ceiling wall opening portion 46 provided in the first ceiling wall CW1. Specifically, the fuel cell room R1 is connected to the left duct room R4L via the ceiling wall opening portion 46 and the fuel cell room upper duct 42. The above-described downstream ventilation fan 41 is disposed in the ceiling wall opening portion 46.

Since the left duct room R4L has such a structure, when the left duct room R4L does not have a rainwater entry prevention structure, rainwater that has entered the left duct room R4L from the upper surface left opening portion 134 may enter the fuel cell room R1 via the ceiling wall opening portion 46. In consideration of this point, the left duct room R4L includes a ventilation route forming member 51 that is disposed below the upper surface left opening portion 134 and has, on the upper surface, an inclined surface 51a that is inclined with respect to a horizontal plane.

When an upper surface of the ventilation route forming member 51 has the inclined surface 51a, rainwater entering the left duct room R4L can be bounced back toward a side opposite to the upstream side of the ventilation flow. Furthermore, when the upper surface of the ventilation route forming member 51 has the inclined surface 51a, it is possible to prevent rainwater from flowing toward the upstream side of the ventilation flow while increasing a size of a range in which the upper surface left opening portion 134 can be disposed, as compared with a structure in which the upper surface is a horizontal surface.

Specifically, the ventilation route forming member 51 has a rear wall 511, an upper wall 512, and a left side wall 513. The rear wall 511 has a rectangular plate shape parallel to the up-down direction. The upper wall 512 has a rectangular plate shape, extends rearward from an upper end portion of the rear wall 511, and is inclined such that a height position of the upper wall 512 becomes higher toward the rear. The upper wall 512 constitutes the above-described inclined surface 51a. The left side wall 513 has a trapezoidal plate shape, extends rearward from a left end portion of the rear wall 511, and extends downward from a left end portion of the upper wall 512.

The ventilation route forming member 51 having such a shape is fixed to the first ceiling wall CW1 that constitutes a bottom surface of the left duct room R4L and the second partition wall PW2 that constitutes the right side surface of the left duct room R4L with fasteners, such as bolts. The ventilation route forming member 51 is disposed to cover a ventilation outlet 42a (an opening provided in the second partition wall PW2) of the fuel cell room upper duct 42. Specifically, the front end portion of the ventilation route forming member 51 is positioned in front of the outlet 42a.

As illustrated in FIG. 12, the ventilation flow that has entered the left duct room R4L from the fuel cell room R1 via the downstream ventilation fan 41 and the fuel cell room upper duct 42 (including the outlet 42a) enters the space SP1 surrounded by the ventilation route forming member 51, the first ceiling wall CW1, and the second partition wall PW2. Then, the ventilation flow that has exited from the exit portion provided in front of the space SP1 moves upward toward the upper surface left opening portion 134 and exits from the upper surface left opening portion 134 to the outside of the housing 10.

The inclined surface 51a disposed below the upper surface left opening portion 134 formed in a rectangular region extending in the front-rear direction is provided over a range overlapping with at least the upper surface left opening portion 134 in plan view. The rainwater that has entered the left duct room R4L from the upper surface left opening portion 134 is highly likely to be bounced back as illustrated in FIG. 12 (see black thick arrows). The rainwater bounced back toward the rear is discharged to the outside of the housing 10 through a drain passage (not illustrated). Thus, it is possible to reduce the possibility that rainwater having entered the left duct room R4L reaches the ceiling wall opening portion 46.

Note that the rainwater obliquely entering forward from the upper surface left opening portion 134 may reach the bottom surface of the left duct room R4L without hitting the inclined surface 51a. However, in this embodiment, the ceiling wall opening portion 46 is formed at a position deviated from the upper surface left opening portion 134 in plan view. Specifically, the ceiling wall opening portion 46 is located away from the left duct room R4L (second partition wall PW2) on the right side. Thus, the possibility that rainwater that has reached the bottom surface of the left duct room R4L enters the fuel cell room R1 via the ceiling wall opening portion 46 can be reduced. In this embodiment, the outlet 42a of the fuel cell room upper duct 42 is located at a position higher than the bottom surface of the left duct room R4L. This also reduces the possibility that rainwater that has reached the bottom surface of the left duct room R4L enters the fuel cell room R1 via the ceiling wall opening portion 46.

### 2-3-2. Right Duct Room

Next, the right duct room R4R will be described. The right duct room R4R is for the above-described electrical equipment room ventilation route VR2.

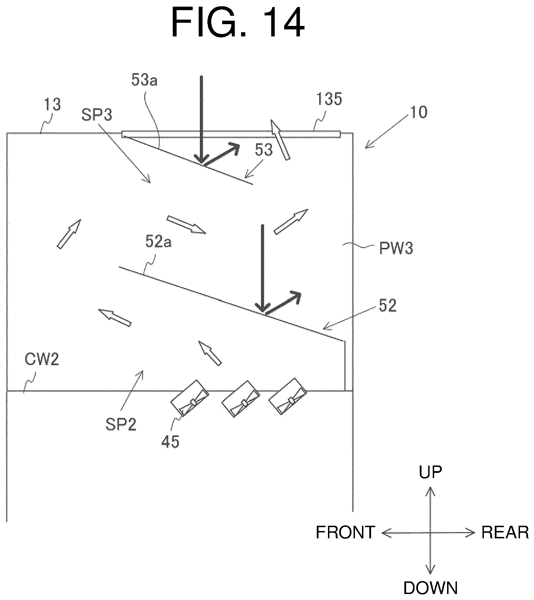

FIG. 13A is a first perspective view for explaining an internal structure of the right duct room R4R. FIG. 13B is a second perspective view for explaining the internal structure of the right duct room R4R. FIG. 14 is a diagram schematically illustrating operation of the right duct room R4R. FIGS. 13A and 13B illustrate a state where some members provided on the right side surface of the right duct room R4R are removed. A direction in which the right duct room R4R is viewed is different between the diagram illustrated in FIG. 13A (first perspective view) and the diagram illustrated in FIG. 13B (second perspective view). Both FIGS. 13A and 13B are diagrams of the right duct room R4R as viewed from the right surface side, but FIG. 13A is a diagram as viewed from obliquely above on the front side, and FIG. 13B is a diagram as viewed from obliquely above on the rear side. Furthermore, white arrows in FIG. 14 indicate directions in which the ventilation flow flows. Thick solid arrows illustrated in FIG. 14 indicate movements of rainwater.

As illustrated in FIGS. 7, 8, 13A, and 13B, the housing 10 has, below the right duct room R4R, the electrical equipment room R2 (room) partitioned from the right duct room R4R by the second ceiling wall CW2. The electrical equipment room R2 is connected to the right duct room R4R via the ceiling wall opening portion 47 formed in the second ceiling wall CW2. Note that the above-described shared ventilation fans 45 are disposed in the ceiling wall opening portion 47.

Since the right duct room R4R has such a structure, when no rainwater entry prevention structure is provided in the right duct room R4R, rainwater that has entered the right duct room R4R from the upper surface right opening portion 135 may enter the electrical equipment room R2 via the ceiling wall opening portion 46. In consideration of this point, the right duct room R4R includes ventilation route forming members 52 and 53 that are disposed below the upper surface right opening portion 135 and have, on the upper surface, inclined surfaces 52a and 53a, respectively, that are inclined with respect to a horizontal plane.

Since upper surfaces of the ventilation route forming members 52 and 53 have the inclined surfaces 52a and 53a, respectively, rainwater entering the right duct room R4R can be easily bounced back in a specific direction that is convenient for drainage. Since the ventilation route forming members 52 and 53 having the inclined surfaces 52a and 53a, respectively, are included in the right duct room R4R, it is possible to prevent rainwater from flowing toward the ventilation inlet (ceiling wall opening portion 47) on the right duct room R4R while widening a range in which the upper surface right opening portion 135 is formed.

Unlike the case of the left duct room R4L, the ceiling wall opening portion 47 is formed in the right duct room R4R at a position overlapping with the upper surface right opening portion 135 in plan view. In other words, the ceiling wall opening portion 47 is formed in the bottom surface of the right duct room R4R. Therefore, as for the right duct room R4R, rainwater that has entered the duct room from the upper surface opening portion more easily enters the room provided below the duct room when compared with the left duct room R4L.

In consideration of this point, the plurality of ventilation route forming members 52 and 53 are arranged to overlap with each other in the up-down direction in the right duct room R4R. Since the plurality of ventilation route forming members 52 and 53 are disposed, a distance from the upper surface right opening portion 135 to the ceiling wall opening portion 47 located on the upstream of the ventilation flow can be increased. Since the ventilation route forming members 52 and 53 having the inclined surfaces 52a and 53a, respectively, on the upper surface are disposed to overlap with each other in the up-down direction, the probability of causing rainwater entering the right duct room R4R from the upper surface right opening portion 135 to bounce back in a specific direction can be increased. That is, since the plurality of ventilation route forming members 52 and 53 are arranged to overlap with each other in the up-down direction, the possibility that rainwater enters the electrical equipment room R2 via the ceiling wall opening portion 47 can be further reduced.

Specifically, the first ventilation route forming member 52 is disposed in the right duct room R4R so as to cover the ceiling wall opening portion 47. The first ventilation route forming member 52 has a rear wall 521, an upper wall 522 that constitutes the inclined surface 52a, and a right side wall 523. The structure of the first ventilation route forming member 52 is the same as the structure of the ventilation route forming member 51 that is disposed in the left duct room R4L, except that the left-right positions of the side walls are opposite to those of the ventilation route forming member 51, and therefore will not be described in detail. The first ventilation route forming member 52 is fixed to the second ceiling wall CW2 that constitutes the bottom surface of the right duct room R4R and the third partition wall PW3 that constitutes a left side surface of the right duct room R4R with fasteners, such as bolts.

The second ventilation route forming member 53 has an upper wall 531 and a right side wall 532. The upper wall 531 has a rectangular plate shape and is disposed above the upper wall 522 of the first ventilation route forming member 52. The upper wall 531 is preferably arranged parallel to the upper wall 522 of the first ventilation route forming member 52. The upper wall 531 constitutes the above-described inclined surface 53a. The right side wall 532 has a trapezoidal plate shape and extends downward from a right end portion of the upper wall 531.

The second ventilation route forming member 53 is fixed to the upper surface cover 13, the third partition wall PW3, and the first ventilation route forming member 52 using fasteners, such as bolts. Specifically, a front end portion of the upper wall 531 of the second ventilation route forming member 53 is fixed to the lower surface of the upper surface cover 13 via a seal member (not illustrated). The left end portion of the upper wall 531 of the second ventilation route forming member 53 is fixed to the third partition wall PW3. The right side wall 532 of the second ventilation route forming member 53 is fixed to the right side wall 523 of the first ventilation route forming member 52.

The upper wall 531 of the second ventilation route forming member 53 overlaps with the upper wall 522 of the first ventilation route forming member 52 in plan view. Specifically, the front end portion of the upper wall 531 of the second ventilation route forming member 53 is located at the same position as the front end portion of the upper wall 522 of the first ventilation route forming member 52 in plan view. A rear end portion of the upper wall 531 of the second ventilation route forming member 53 is located on the front side of the rear end portion of the upper wall 522 of the first ventilation route forming member 52 in plan view. That is, in plan view, the upper wall 531 of the second ventilation route forming member 53 does not completely overlap with the upper wall 522 of the first ventilation route forming member 52. In plan view, a portion of the upper wall of the first ventilation route forming member 52 protrudes rearward with respect to the upper wall 531 of the second ventilation route forming member 53.

As illustrated in FIG. 14, the ventilation flow that has entered the right duct room R4R from the electrical equipment room R2 via the shared ventilation fans 45 enters the first space SP2 surrounded by the first ventilation route forming member 52, the second ceiling wall CW2, and the third partition wall PW3, and flows forward. The ventilation flow that has exited from an exit portion provided in front of the first space SP2 rises, enters the second space SP3 surrounded by the first ventilation route forming member 52, the second ventilation route forming member 53, and the third partition wall PW3, and flows rearward. The ventilation flow that has exited from an exit portion provided at the rear of the second space SP3 flows toward the upper surface right opening portion 135 and exits to the outside of the housing 10 from the upper surface right opening portion 135.

In plan view, the inclined surface 53a of the second ventilation route forming member 53 is present in a range overlapping with the upper surface right opening portion 135, or the inclined surface 52a of the first ventilation route forming member 52 is present in a portion where the inclined surface 53a is not present. A front end portion of the inclined surface 52a of the first ventilation route forming member 52 is present on the front side with respect to a rear end portion of the inclined surface 53a of the second ventilation route forming member 53, and the inclined surface 52a of the first ventilation route forming member 52 is located under the inclined surface 53a of the second ventilation route forming member 53.

With such a structure, as illustrated in FIG. 14, rainwater that has entered the right duct room R4R from the upper surface right opening portion 135 can be more likely to be bounced back by the inclined surface 52a of the first ventilation route forming member 52 or the inclined surface 53a of the second ventilation route forming member 53. Then, the rainwater bounced back toward the rear is discharged to the outside of the housing 10 through a drain passage (not illustrated). Therefore, it is possible to reduce the possibility that rainwater enters the first space SP2 from the exit portion on the front side of the first space SP2 and reaches the ceiling wall opening portion 47.

### 3. Notes

Various technical features disclosed in this specification can be changed in various ways without departing from the spirit of the technical creation thereof. In addition, the plurality of embodiments and modifications described in this specification may be embodied in combinations within a range to the extent possible.

### 4. Appendices

An exemplary fuel cell system according to the present invention may be configured to include a housing having a fuel cell room including a fuel cell module, and an electrical equipment room that is partitioned from the fuel cell room and that includes a plurality of electrical devices. The housing includes a fuel cell room ventilation route that ventilates the fuel cell room, and an electrical equipment room ventilation route that ventilates the electrical equipment room (first configuration).

In the fuel cell system according to the first configuration, a configuration (second configuration) may be employed in which the fuel cell room includes a downstream ventilation fan that is disposed at a position on a downstream of a ventilation flow that flows through the fuel cell room ventilation route, and the electrical equipment room includes an upstream ventilation fan disposed at a position on an upstream of the ventilation flow that flows through the electrical equipment room ventilation route.

The fuel cell system according to the second configuration may be configured such that when the fuel cell module is in operation, at least one of the downstream ventilation fan and the upstream ventilation fan is in operation, and air pressure of the electrical equipment room is higher than air pressure of the fuel cell room (third configuration).

In the fuel cell system according to the second and third configurations, a configuration may be employed in which the fuel cell room includes a floor wall having a ventilation portion through which an airflow from an inlet of the fuel cell room ventilation route passes, and a ceiling wall on which the downstream ventilation fan is disposed (fourth configuration).

In the fuel cell system according to the fourth configuration, a configuration may be employed in which the housing includes, on an upper side of the ceiling wall, a radiator room accommodating a radiator that cools the fuel cell module, and the downstream ventilation fan is disposed with a rotation shaft inclined with respect to an up-down direction (fifth configuration).

An exemplary fuel cell system according to the present invention may be configured to include a housing having a fuel cell room including a fuel cell module, and an electrical equipment room that is partitioned from the fuel cell room and that includes a plurality of electrical devices. The electrical equipment room includes a plurality of ventilation routes (sixth configuration).

In the fuel cell system according to the sixth configuration, a configuration (seventh configuration) may be employed in which the plurality of electrical devices include an inverter and a battery that are electrically connected to the fuel cell module, and the plurality of ventilation routes include an inverter ventilation route that ventilates an inverter case accommodating the inverter, and a battery ventilation route that ventilates a battery case accommodating the battery.

The fuel cell system according to the seventh configuration may include an inverter ventilation fan disposed in the inverter ventilation route, and a battery ventilation fan disposed in the battery ventilation route (eighth configuration).

In the fuel cell system according to the eighth embodiment, a configuration (ninth configuration) may be employed in which the inverter ventilation fan is disposed at a position on an upstream of the inverter in a ventilation flow in the inverter ventilation route.

In the fuel cell system having the sixth or seventh configuration, a configuration (tenth configuration) may be employed in which the battery ventilation fan is disposed at a position on a downstream of a ventilation flow with respect to the battery in the battery ventilation route.

In the fuel cell system according to any one of the sixth to tenth configurations, a configuration (11th configuration) may be employed in which the electrical equipment room includes a merging portion where the inverter ventilation route and the battery ventilation route merge with each other, and a shared ventilation fan is disposed at a position on a downstream of a ventilating flow with respect to the merging portion.

In the fuel cell system according to any one of the sixth to 11th configurations, a configuration (12th configuration) may be employed in which a ventilation flow flowing through the battery ventilation route hits an outer surface of the inverter case.

Furthermore, the exemplary fuel cell system according to the present invention may be configured such that the fuel cell system includes a housing accommodating a fuel cell module, the housing has a ventilation route that ventilates the inside, an inlet of the ventilation route is formed on a side surface of the housing, and an outlet of the ventilation route is formed on an upper surface of the housing (13th configuration).

In the fuel cell system according to the 13th configuration, a configuration (14th configuration) may be employed in which the outlets are upper surface opening portions formed in the upper surface of the housing, the housing includes a duct room that is connected to the upper surface opening portions and that constitutes portions of the ventilation routes, and the duct room includes a ventilation route forming member that is disposed below the upper surface opening portions and that has an inclined surface inclined with respect to a horizontal plane on an upper surface.

In the fuel cell system according to the 14th configuration, a configuration (15th configuration) may be employed in which the ventilation route forming members are disposed in the duct room so as to be stacked in an up-down direction.

In the fuel cell system according to the 14th or 15th configuration, a configuration (16th configuration) may be employed in which the housing has, below the duct room, a room partitioned from the duct room by a ceiling wall, and the room is connected to the duct room via a ceiling wall opening portion formed in the ceiling wall.

In the fuel cell system according to the 16th configuration, a configuration (17th configuration) may be employed in which the ceiling wall opening portion is formed at a position deviated from the upper surface opening portions in plan view.

In the fuel cell system according to the 16th or 17th configuration, a configuration (18th configuration) may be employed in which the room includes a fuel cell room including the fuel cell module and an electrical equipment room that is partitioned from the fuel cell room and that includes a plurality of electrical devices, and the housing includes a duct room provided for the fuel cell room and a duct room provided for the electrical equipment room.

In the fuel cell system according to the 18th configuration, a configuration (19th configuration) may be employed in which the housing includes the fuel cell room and the electrical equipment room, a radiator room accommodating a radiator that cools the fuel cell module, and the radiator room is provided between the duct room provided for the fuel cell room and the duct room provided for the electrical equipment room.

An exemplary monogeneration device of the present invention may have a configuration (20th configuration) including the fuel cell system of any one of the first to 19th configurations.

### REFERENCE SIGNS LIST

1 Fuel cell system
2 Fuel cell module
3 Battery (electrical device)
3C Battery case
4 Inverter (electrical device)
4C Inverter case
5 Control device (electrical device)
6 Gas detector
10 Housing
41 Downstream ventilation fan
43 Upstream ventilation fan
43a Inverter ventilation fan
43b Battery ventilation fan
45 Shared ventilation fan
46, 47 ceiling wall opening portion
51 Ventilation route forming member
51a Inclined surface
52 First ventilation route forming member
52a Inclined surface
53 Second ventilation route forming member
53a Inclined surface
134 Upper surface left opening portion (upper surface opening portion)
135 Upper surface right opening portion (upper surface opening portion)
171, 211 Slits
713 First heat exchanger (radiator)
724 Second heat exchanger (radiator)
MG Monogeneration Device
CW1 First ceiling wall (ceiling wall of fuel cell room)
CW2 Second ceiling wall (ceiling wall of electrical equipment room)
FW1 First floor wall (floor wall of fuel cell room)
R1 Fuel cell room
R2 Electrical equipment room
R3 Radiator room
R4 Duct room
R4L Left duct room
R4R Right duct room
VR Ventilation route
VR1 Fuel cell room ventilation route
VR2 Electrical equipment room ventilation route
VR2a Inverter ventilation route
VR2b Battery ventilation route

## Claims

1. A fuel cell system, comprising:
a housing having
a fuel cell room including a fuel cell module, and
an electrical equipment room that is partitioned from the fuel cell room and that includes a plurality of electrical devices, wherein
the housing includes
a fuel cell room ventilation route that ventilates the fuel cell room, and
an electrical equipment room ventilation route that ventilates the electrical equipment room.

2. The fuel cell system according to claim 1, wherein
the fuel cell room includes a downstream ventilation fan that is disposed at a position on a downstream of a ventilation flow that flows through the fuel cell room ventilation route, and
the electrical equipment room includes an upstream ventilation fan disposed at a position on an upstream of the ventilation flow that flows through the electrical equipment room ventilation route.

3. The fuel cell system according to claim 2, wherein when the fuel cell module is in operation, at least one of the downstream ventilation fan and the upstream ventilation fan is in operation, and air pressure of the electrical equipment room is higher than air pressure of the fuel cell room.

4. The fuel cell system according to claim 2, wherein
the fuel cell room has
a floor wall having a ventilation portion through which an airflow from an inlet of the fuel cell room ventilation route passes, and
a ceiling wall on which the downstream ventilation fan is disposed.

5. The fuel cell system according to claim 4, wherein
the housing includes, on an upper side of the ceiling wall, a radiator room accommodating a radiator that cools the fuel cell module, and
the downstream ventilation fan is disposed with a rotation shaft inclined with respect to an up-down direction.

6. The fuel cell system according to claim 1, wherein the electrical equipment room ventilation route includes a plurality of ventilation routes.

7. The fuel cell system according to claim 6, wherein
the plurality of electrical devices include an inverter and a battery that are electrically connected to the fuel cell module, and
the plurality of ventilation routes include
an inverter ventilation route that ventilates an inverter case accommodating the inverter, and
a battery ventilation route that ventilates a battery case accommodating the battery.

8. The fuel cell system according to claim 7, further comprising:
an inverter ventilation fan disposed in the inverter ventilation route; and
a battery ventilation fan disposed in the battery ventilation route.

9. The fuel cell system according to claim 8, wherein the inverter ventilation fan is disposed at a position on an upstream of the inverter in a ventilation flow in the inverter ventilation route.

10. The fuel cell system according to claim 8, wherein the battery ventilation fan is disposed at a position on a downstream of a ventilation flow with respect to the battery in the battery ventilation route.

11. The fuel cell system according to claim 7, wherein
the electrical equipment room includes a merging portion where the inverter ventilation route and the battery ventilation route merge with each other, and
a shared ventilation fan is disposed at a position on a downstream of a ventilating flow with respect to the merging portion.

12. The fuel cell system according to claim 7, wherein a ventilation flow flowing through the battery ventilation route hits an outer surface of the inverter case.

13. The fuel cell system according to claim 1, wherein
an inlet of the fuel cell room ventilation route and an inlet of the electrical equipment room ventilation route are formed in a side surface of the housing, and
an outlet of the fuel cell room ventilation route and an outlet of the electrical equipment room ventilation route are formed on an upper surface of the housing.

14. The fuel cell system according to claim 13, wherein
the outlet of the fuel cell room ventilation route and the outlet of the electrical equipment room ventilation route are upper surface opening portions formed in the upper surface of the housing,
the housing includes a duct room that is connected to the upper surface opening portions and that constitutes portions of the ventilation routes, and
the duct room includes a ventilation route forming member that is disposed below the upper surface opening portions and that has an inclined surface inclined with respect to a horizontal plane on an upper surface of the duct room.

15. The fuel cell system according to claim 14, wherein a plurality of the ventilation route forming member are disposed in the duct room to be stacked in an up-down direction.

16. The fuel cell system according to claim 14, wherein
the housing includes, below the duct room, a room that is partitioned from the duct room by a ceiling wall, and
the room is connected to the duct room via a ceiling wall opening portion formed in the ceiling wall.

17. The fuel cell system according to claim 16, wherein the ceiling wall opening portion is formed at a position deviated from the upper surface opening portions in plan view.

18. The fuel cell system according to claim 16, comprising:
the duct room provided for the fuel cell room; and
the duct room provided for the electrical equipment room.

19. The fuel cell system according to claim 18, wherein
the housing includes, above the fuel cell room and the electrical equipment room, a radiator room accommodating a radiator that cools the fuel cell module, and
the radiator room is provided between the duct room provided for the fuel cell room and the duct room provided for the electrical equipment room.

20. A monogeneration device, comprising the fuel cell system according to any one of claims 1 to 19.
